# EUROPEAN PATENT APPLICATION

(11) **EP 1 586 600 A1**
(43) Date of publication of application: **19.10.2005**
(21) Application number: 03758858.9
(22) Date of filing: 24.10.2003
(51) Int. Cl.: C08G 73/08, C09K 11/06, H05B 33/14

(54) **LUMINESCENT POLYMERS AND LIGHT EMITTING DEVICES**

(30) Priority: 29.10.2002 JP 2002315029
(71) Applicant: HIROSE ENGINEERING CO., LTD., Tokyo 146-0092 (JP)
(72) Inventor: NAKAYA, Tadao c/o Hirose Engineering Co., Ltd., Ohta-ku, Tokyo 146-0092 (JP); TOBITA, Michiaki c/o Hirose Engineering Co., Ltd., Ohta-ku, Tokyo 146-0092 (JP); ETOH, Naonobu c/o Hirose Engineering Co., Ltd., Ohta-ku, Tokyo 146-0092 (JP); KODERA, Toshihiro c/o Hirose Engineering Co., Ltd., Ohta-ku, Tokyo 146-0092 (JP)
(74) Representative: Olgemöller, Luitgard Maria
(86) International application number: PCT/JP2003/013597
(87) International publication number: WO 2004/039866

(57) **Abstract**

The present invention provides luminescent polymers which can easily be formed into a film or a sheet, and which can easily be incorporated into a luminescent element. The present invention also provides luminescent elements which can be produced easily by the employment of the luminescent polymers . One of the luminescent polymers has a repeating unit represented by formula (1) : 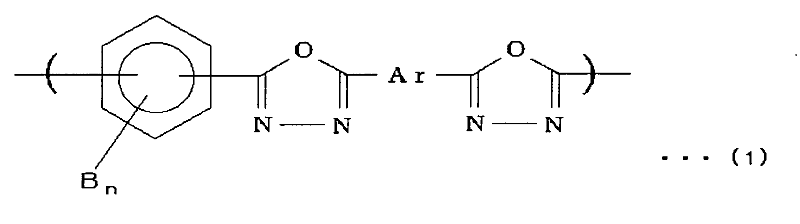 wherein Ar is a group represented by one of formulas (2) - (5) ; B is -Y-Ar¹, -Y-R, or a hydrogen atom, wherein Y is a single bond or -O-, Ar¹ is a group represented by formula (6), and R is an alkyl group or an alkenyl group; n denotes an integer from 1 to 4, wherein Bs may be the same or different from each other when n is 2, 3, or 4, at least one of the Bs in formula (1) must be -Y-Ar¹ or -Y-R when B or Bs in formula (2), (3), (4) or (5) are a hydrogen atom or hydrogen atoms, and at least one of the Bs in the group represented by any one of formulas (2) - (5) must be -Y-Ar¹ or -Y-R when B or Bs bonded to the benzene ring in formula (1) are a hydrogen atom or hydrogen atoms.

## Description

### Technical Field

The present invention relates to luminescent polymers and luminescent elements. More specifically, the present invention relates to luminescent polymers which can easily be formed into a film or a sheet, which can easily be incorporated into a luminescent element, and which can provide a luminescent element capable of emitting blue light at high luminance. The invention also provides luminescent elements capable of emitting blue light at high luminance.

### Background Art

Polyoxadiazole is known as a polymer that has oxadiazolylene groups in its main polymer chain. This is mentioned, for example, on page 219 of a book entitled "New Synthetic Resin", which is volume 4 of the work entitled "New Synthetic Chemistry" edited by Minoru Imoto, published by Kyoritsu Shuppan Co., Ltd. on October 1, 1964 (first edition) .

The mentioned polyoxadiazole, represented by formula (11), is known as a heat-resistant synthetic fiber.

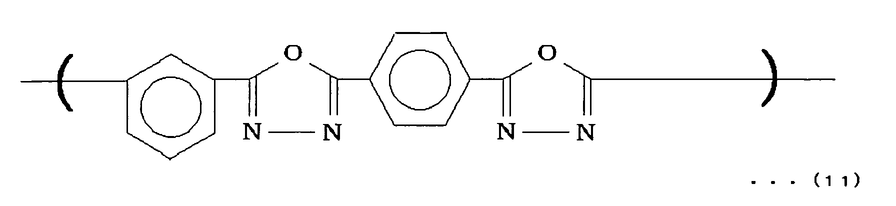

However, the book does not state that this polyoadiazole emits light upon the application of energy such as electric current.

When a light emitting substance that emits light at high luminance upon the application of energy is developed, it can be applicable to displays such as organic EL panels. See "LCD", a feature article of the May, 2001 issue of "NIKKEI MICRODEVICES" on pages 93-102.

However, high molecular weight luminescent substances have not been developed yet. High molecular weight luminescent substances, or luminescent polymers, when they are developed, will produce several industrial improvements. For example, the process of incorporating a luminescent polymer into an organic EL element will not require a step or a series of steps that is essential with a process in which a low molecular weight luminescent compound is incorporated into an organic EL element. Specifically can be omitted a step in which a low molecular weight luminescent compound is deposited on a substrate, a series of steps in which a low molecular weight luminescent compound is dissolved in a solvent, the obtained solution is allowed to flow over the surface of a substrate with an electrode, and the solvent is removed, or another series of steps in which a low molecular weight compound is dispersed in a polymer and the resultant polymer composition is layered in the form of a film on the surface of a substrate.

An objective of the present invention is to provide luminescent polymers that can easily be incorporated into luminescent elements, and luminescent elements that can easily be produced by the use of the luminescent polymers.

### Summary of the Invention

In order to achieve the objective, the present invention provides a luminescent polymer having a repeating unit represented by formula (1): 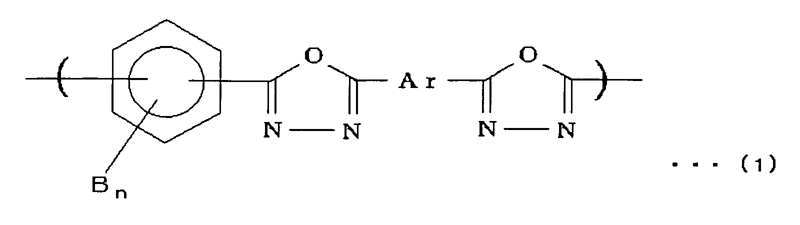 wherein Ar is a group represented by one of formulas (2) - (5) ; B is -Y-Ar¹, -Y-R, or a hydrogen atom, wherein Y is a single bond or -O-, Ar¹ is a group represented by formula (6), and R is an alkyl group or an alkenyl group; and n denotes an integer from 1 to 4, wherein Bs may be the same or different from each other, when n is 2, 3, or 4; at least one of the Bs in formula (1) is -Y-Ar¹ or -Y-R, when B or Bs in formula (2), (3), (4) or (5) are a hydrogen atom or hydrogen atoms; and at least one of the Bs in the group represented by any one of formulas (2) - (5) is -Y-Ar¹ or -Y-R, when B or Bs bonded to the benzene ring in formula (1) are a hydrogen atom or hydrogen atoms.

The group represented by formula (2) is: 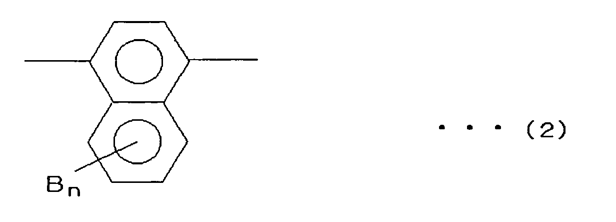 wherein B in formula (2) is the same as that defined in the explanation of repeating unit represented by formula (1); n denotes an integer of 1 to 4; and when n is 2, 3, or 4, Bs may be the same or different from each other.

The group represented by the formula (3) is: 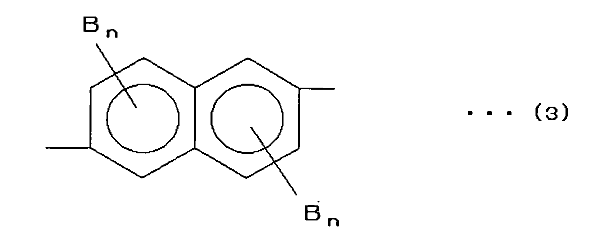 wherein each of the Bs in formula (3) is the same as that defined in the explanation of repeating unit represented by formula (1); n denotes an integer of 1 to 3; and Bs may be the same or different from each other.

The group represented by the formula (4) is: 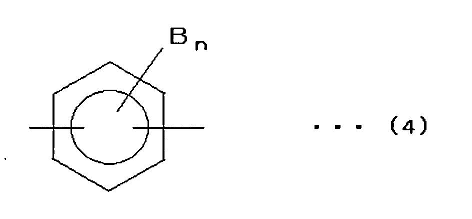 wherein B in formula (4) means the same as that defined in the explanation of repeating unit represented by formula (1); n denotes an integer of 1 to 4; and when n is 2, 3, or 4, Bs may be the same or different from each other.

The group represented by the formula (5) is: 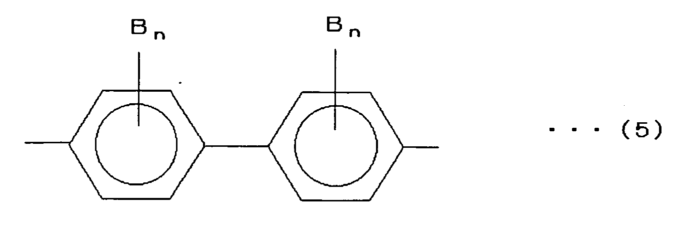 wherein each of the Bs is the same as that defined in the explanation of repeating unit represented by formula (1); n denotes an integer of 1 to 4; and Bs may be the same or different from each other.

The group represented by the formula (6) is: 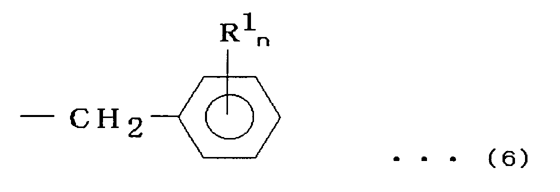 wherein R¹ is a hydrogen atom or an alkyl group; and n denotes an integer of 1-5.

A preferable example of the luminescent polymer is one having a repeating unit represented by formula (7): 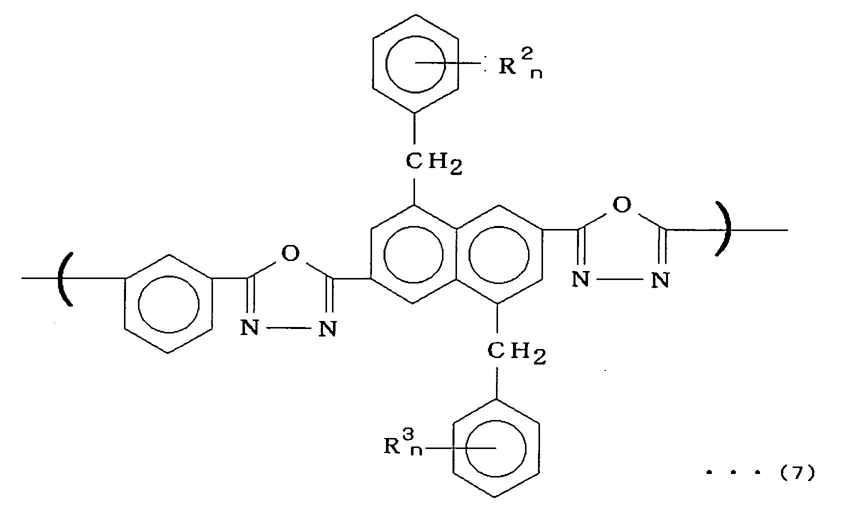 wherein each of R² and R³ is an alkyl group; n denotes an integer of 1-5; when n is 2, 3, 4 or 5, R²s may be the same or different from each other and R³s may be the same or different from each other; and R²(s) and R³(s) may be the same or different from each other.

Another preferable example of the luminescent polymer is one having a repeating unit represented by formula (8): 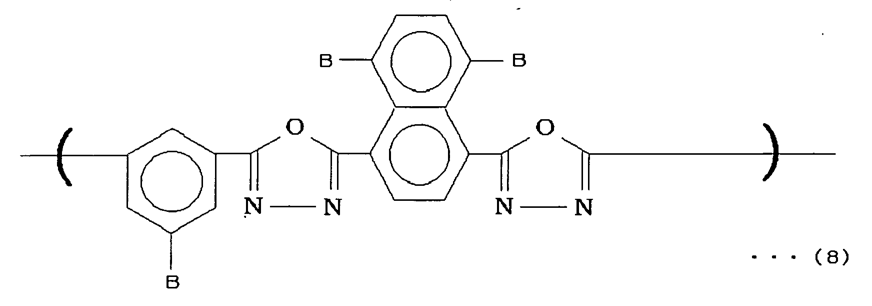 wherein each of the Bs in formula (8) means the same as that defined in the explanation of the repeating unit represented by formula (1) ; and at least one of the three Bs is -Y-Ar¹ or -Y-R, wherein Ar¹ and R are the same as those defined in the explanation of the repeating unit represented by formula (1) .

Still another preferable example of the luminescent polymer is one having a repeating unit represented by formula (9) : 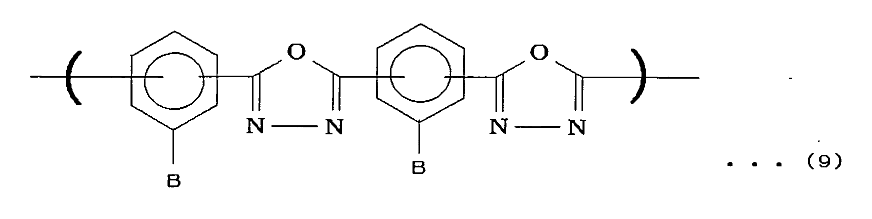 wherein each B in formula (9) is the same as that defined in the explanation of the repeating unit represented by formula (1), and at least one of the two Bs is -Y-Ar¹ or -Y-R.

In order to solve the foregoing problem, the present invention provides another luminescent polymer having a repeating unit represented by formula (10): 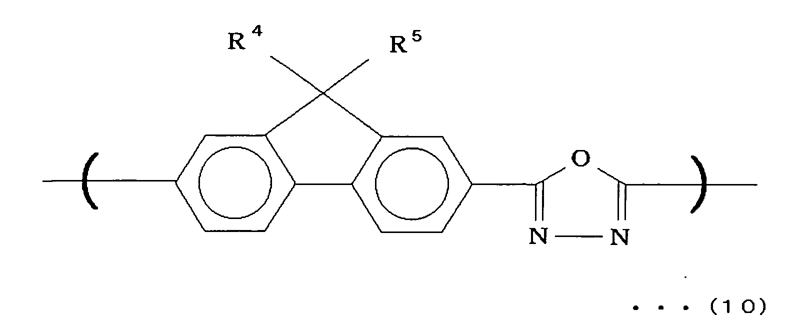 wherein each of R⁴ and R⁵ is an alkyl group, and R⁴ and R⁵ may be the same or different from each other.

Furthermore, the present invention provides a luminescent element which has a film of one of the luminescent polymers above between a pair of electrodes.

### Brief Description of the Drawings

Figure 1 is an illustration showing an example of the luminescent element in accordance with the present invention.
Figure 2 is an illustration showing another example of the luminescent element in accordance with the present invention.
Figure 3 is an illustration showing a still another example of the luminescent element in accordance with the present invention.
Figure 4 is an illustration showing a further example of the luminescent element in accordance with the present invention.
Figure 5 is an NMR spectrum chart of compound (a) synthesized in Working Example 1.
Figure 6 is an NMR spectrum chart of compound (b) synthesized in Working Example 1.
Figure 7 is an IR spectrum chart of compound (b) synthesized in Working Example 1.
Figure 8 is an NMR spectrum chart of compound (c) synthesized in Working Example 1.
Figure 9 is an IR spectrum chart of compound (c) synthesized in Working Example 1.
Figure 10 is an IR spectrum chart of polymer (e) synthesized in Working Example 1.
Figure 11 is a fluorescence spectrum chart of polymer (e) synthesized in Working Example 1.

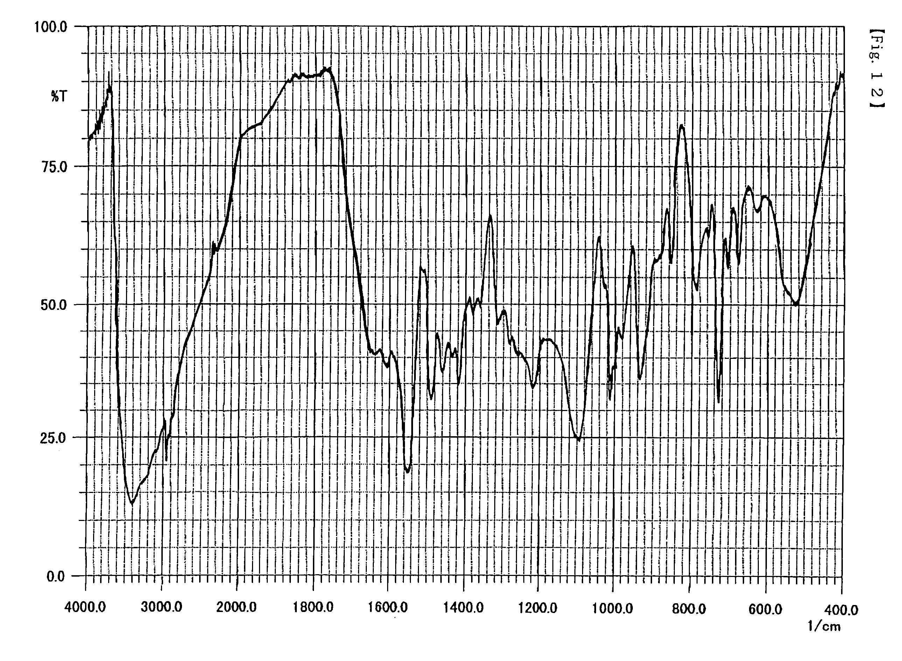

Figure 12 is an IR spectrum chart of polymer (e1) synthesized in Working Example 2.
Figure 13 is a fluorescence spectrum chart of polymer (e1) synthesized in Working Example 2.
Figure 14 is an IR spectrum chart of polymer (e2) synthesized in Working Example 3.
Figure 15 is a fluorescence spectrum chart of polymer (e2) synthesized in Working Example 3.
Figure 16 is an IR spectrum chart of compound (d3) synthesized in Working Example 4.
Figure 17 is an NMR spectrum chart of compound (d3) synthesized in Working Example 4.
Figure 18 is an IR spectrum chart of polymer (e3) synthesized in Working Example 4.
Figure 19 is a fluorescence spectrum chart of polymer (e3) synthesized in Working Example 4.
Figure 20 is an NMR spectrum chart of compound (d6) synthesized in Working Example 5.
Figure 21 is an IR spectrum chart of compound (d6) synthesized in Working Example 5.
Figure 22 is an IR spectrum chart of polymer (e6) synthesized in Working Example 5.
Figure 23 is a fluorescence spectrum chart of polymer (e6) synthesized in Working Example 5.
Figure 24 is an IR spectrum chart of polymer (f7) synthesized in Working Example 6.
Figure 25 is a fluorescence spectrum chart of polymer (f7) synthesized in Working Example 6.
Figure 26 is an IR spectrum chart of polymer (d8) synthesized in Working Example 7.
Figure 27 is a fluorescence spectrum chart of polymer (d8) synthesized in Working Example 7.
Figure 28 is an IR spectrum chart of polymer (b9) synthesized in Working Example 8.
Figure 29 is a fluorescence spectrum chart of polymer (b9) synthesized in Working Example 8.
Figure 30 is an IR spectrum chart of polymer (b10) synthesized in Working Example 9.
Figure 31 is a fluorescence spectrum chart of polymer (b10) synthesized in Working Example 9.
Figure 32 is an IR spectrum chart of polymer (e11) synthesized in Working Example 10.
Figure 33 is a fluorescence spectrum chart of polymer (e11) synthesized in Working Example 10.

### Detailed Description of the Preferred Embodiments

The luminescent polymers according to the present invention have oxadiazole rings and aromatic rings with at least one substituent in their main chains. The luminescent polymers have flexibility because at least one substituent is bonded to each aromatic ring. This flexibility, in turn, enables the formation of a film from the polymer. Also, the substituent bonded to each aromatic ring enhances the luminescent intensity all over the high molecular weight polymer.

One of the luminescent polymers of the present invention, which have the properties mentioned above, has a repeating unit represented by formula (1): 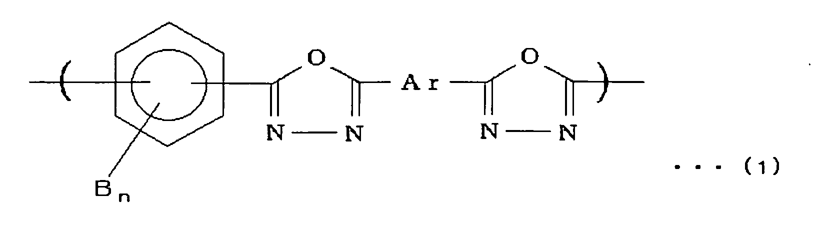 In formula (1), Ar is an aromatic group represented by one of formulas (2)-(5).

The group represented by formula (2) is: 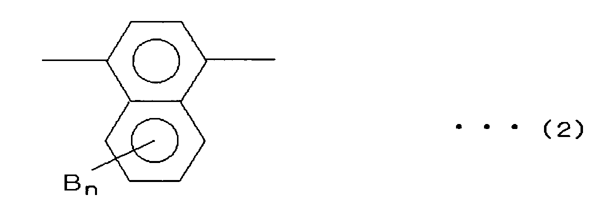 wherein B is -Y-Ar¹, -Y-R, or a hydrogen atom; Y means a single bond or -O-; Ar¹ is a group represented by formula (6); and R is an alkyl group or alkenyl group.

The group represented by formula (6) is: 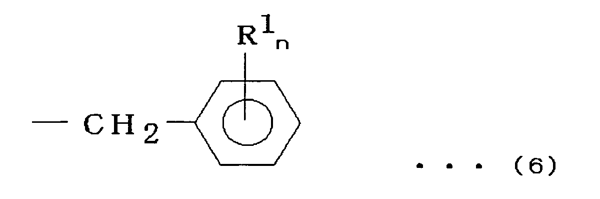 wherein R¹ is a hydrogen atom or an alkyl group. When R¹ is an alkyl group, examples of the alkyl group may be an alkyl group having 20 or less carbon atoms, preferably one having 10 or less carbon atoms, particularly a lower alkyl group having 1-5 carbon atoms. Specific examples of the particularly preferable are methyl group, ethyl group, n-propyl group, i-propyl group, n-butylgroup, 2-butylgroup, tert-butylgroup, etc.

In formula (6), n, which means the number of R¹s that are bonded to the benzene ring, is from 1 to 5. When n is 2 to 5, R¹s may be the same or different from each other.

A preferable group represented by formula (6) is a substituted benzyl group, the 4-positioned or para-positioned hydrogen atom of which is replaced with a lower alkyl group having 1 to 5 carbon atoms.

The alkyl group represented by R in formula (2) should be a lower alkyl group having from 1 to 10 carbon atoms. Specific examples are methyl group, ethyl group, n-propyl group, i-propyl group, n-butyl group, 2-butyl group, tert-butyl group, etc. Also, the alkenyl group represented by R in the same formula may have the double bond at the terminal part of the carbon chain or at a non-terminal part thereof. A preferable alkenyl group has 20 or less carbon atoms.

The group represented by formula (3) is: 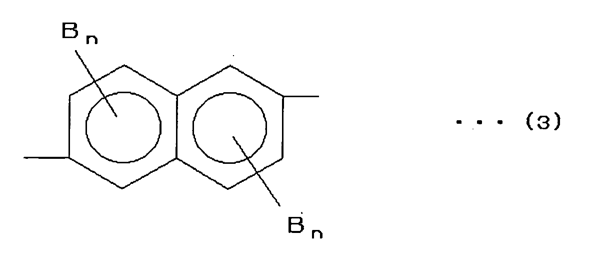 In formula (3), which shows an example of Ar in formula (1), B means the same as that defined in the explanation of formula (2) above. n, which means the number of Bs bonded to each benzene fragment of the naphthylene group, is 1 to 3. When n is 2 or 3, Bs bonded to each one of the benzene fragments may be the same or different from each other . Also, Bs bonded to one benzene fragment may be the same or different from Bs bonded to the other benzene fragment. It is preferable if Bs are bonded to the naphthylene group at the 2-position and the 5-position.

The group represented by formula (4) is: 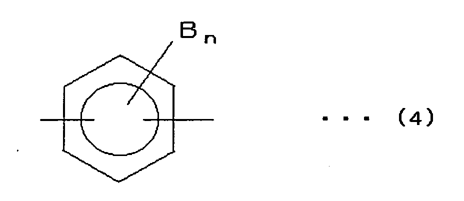 In formula (4), which shows an embodiment of Ar in formula (1), B means the same as that defined in the explanation of formula (2) above. n in formula (4) denotes an integer of 1 to 4. When n is 2, 3 or 4, Bs bonded to the phenylene group may be the same or different from each other.

The group represented by formula (5) is: 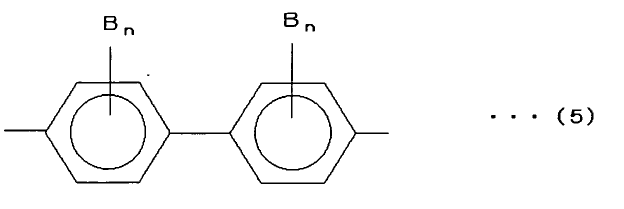 In formula (5), which shows an embodiment of Ar in formula (1), B means the same as that defined in the explanation of formula (2) above. n in formula (5) denotes an integer of 1 to 4. When n is 2, 3 or 4, Bs bonded to each one of the benzene fragments of the biphenylylene group may be the same or different from each other. Also, Bs bonded to one benzene fragment may be the same or different from Bs bonded to the other benzene fragment.

Substituent B bonded to the phenylene group in formula (1) is the same as that defined in the explanation of formula (2) above. n in formula (1), which means the number of Bs bonded to the phenylene group, is an integer of 1 to 4.

Among the luminescent polymers having the repeating units represented by formula (1), preferable polymers have the repeating units represented by formulas (7)-(9).

The repeating unit represented by formula (7) is: 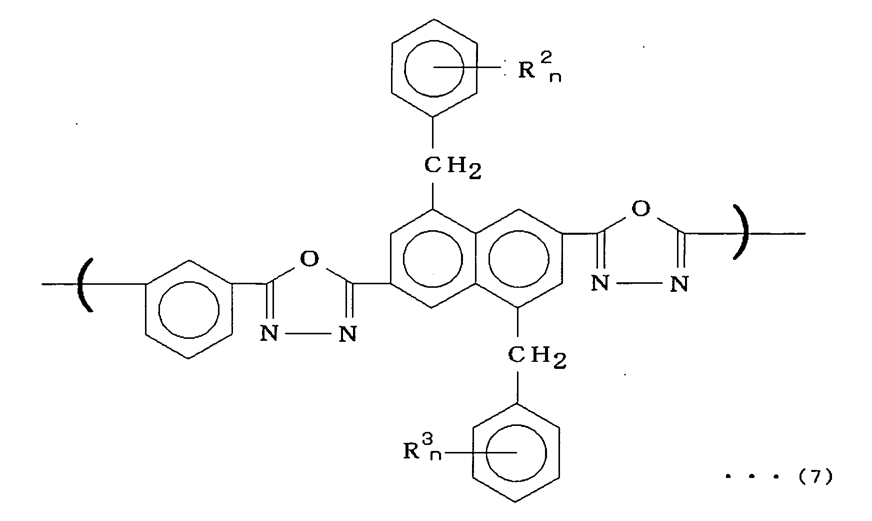 In formula (7), R² and R³ mean alkyl groups. n denotes an integer of 1 to 5. When n is 2, 3, 4 or 5, R²s may be the same or different from each other. The same can be applied to R³s . Also, R²(s) and R³(s) may be the same or different from each other.

Examples of the alkyl group represented by R² or R³ are methyl group, ethyl group, n-propyl group, i-propyl group, n-butyl group, 2-butyl group, t-butyl group, etc. Preferable alkyl groups are lower alkyl groups having 1 to 5 carbon atoms.

In the luminescent polymer having the repeating unit represented by formula (7), the double bonds of each oxadiazolylene group and those of the naphthylene group, which is adjacent to the oxadiazolylene groups, are conjugated. In addition, two phenyl groups are bonded to the naphthylene group through the respective hyperconjugating methylene groups. This structure adjusts the energy differential of π electrons between the ground state and the excited state to, for example, a value that enables the emission of blue light. Also, the alkyl groups represented by R² and R³, which are bonded to the phenyl groups, enable formation of a film from the luminescent polymer, which has the repeating unit represented by formula (7) and is capable of emitting blue light.

The repeating unit represented by formula (8) is: 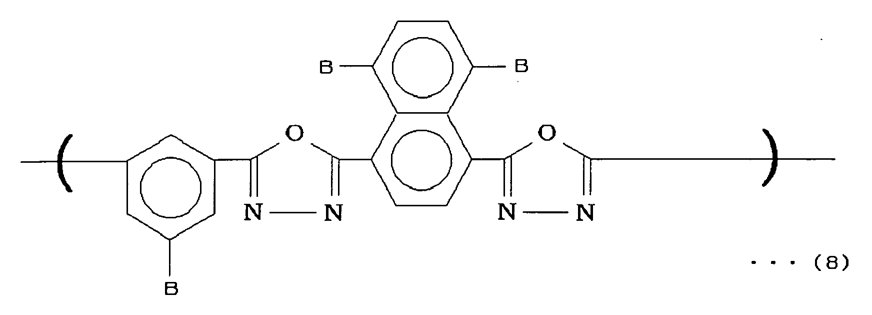 In formula (8), each of the three Bs means the same as that defined in the explanation of formula (2) above. One of the three Bs, which are the B bonded to the phenylene group in the repeating unit of formula (8) and the Bs bonded to the naphthylene group, is -Y-Ar¹ or -Y-R.

The luminescent polymer having the repeating unit represented by formula (8), in the same way as the luminescent polymer having the repeating unit represented by formula (7), can be formed into a film, because of the alkyl groups, which make the polymer flexible, bonded to the rigid and straight main chain, which comprises phenylene groups, oxadiazolylene groups and naphthylene groups. Furthermore, the hyper-conjugation of the double bonds in the phenylene groups, those in the oxadiazolylene groups and those in the naphthylene groups somehow contributes to the realization of the π-electron state that enables the emission of blue light as well as the enhancement of the luminescent intensity of the polymer.

Among the repeating units derived from formula (8), the repeating unit represented by formula (12) and that represented by formula (13) are preferable.

The repeating unit represented by formula (12) is: 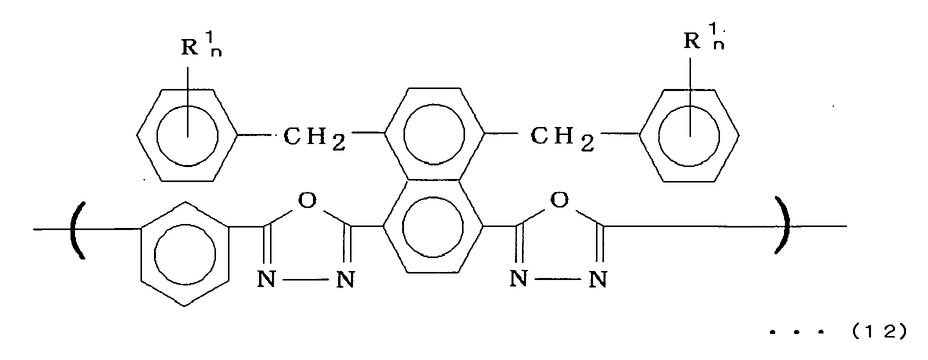 In formula (12), R¹ and n denote the same as those defined in the explanation of formula (6) above. Because the luminescent polymer having the repeating unit represented by formula (12) has a structure in which two phenyl groups are bonded to the naphthylene group through the respective hyperconjugating methylene groups, π electrons in the phenylene group and the oxadiazolylene groups, and π electrons in the phenyl groups of the side chains, bonded to the naphthylene group through the methylene groups, spread over both π-electron areas as a common electron cloud. This electron cloud increases the luminescent intensity. Furthermore, R¹s in the side chains gives the luminescent polymer flexibility enough to be formed into a film.

The repeating unit represented by formula (13) is: 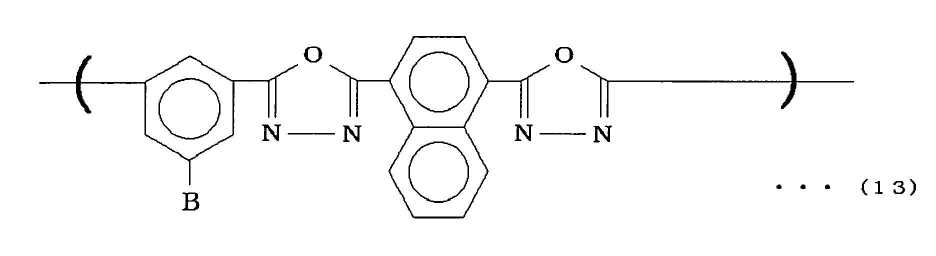 In formula (13), B means the same as that defined in the explanation of formula (2) above.

The luminescent polymer having the repeating unit represented by formula (13) can be formed into a film, because it has substituent B as a side chain. Also, the polymer is luminescent because of π electrons included in the phenylene group and the oxadiazolylene groups of the main chain.

One of the preferable repeating units represented by formula (1) is the repeating unit shown by formula (9): 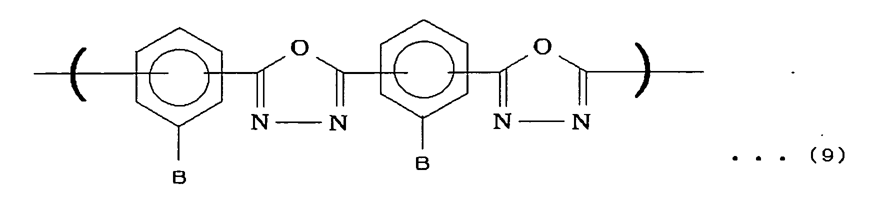 Each of the Bs in formula (9) means the same as B in formula (1). Bs may be the same or different from each other.

Another luminescent polymer provided by the present invention has a repeating unit represented by formula (10). The repeating unit represented by formula (10) is not included in that represented by formula (1). 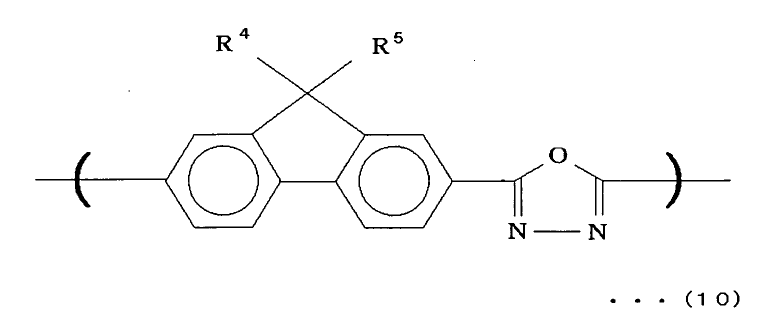 In formula (10), R⁴ and R⁵ are alkyl groups, and they may be the same or different from each other. The alkyl groups represented by R⁴ and R⁵ include methyl group, ethyl group, n-propyl group, i-propyl group, n-butyl group, 2-butyl group, t-butyl group, etc. Preferable alkyl groups are lower alkyl groups having 1 to 10 carbon atoms.

The polymer having a repeating unit represented by formula (10) is luminescent, because π electrons conjugate in the fluorene skeleton and the oxadiazolylene group. Also, the luminescent polymer can be formed into a film due to the fact that R⁴ and R⁵ are bonded to the fluorene skeleton.

The molecular weight of the luminescent polymer having a repeating unit represented by formula (1) or (10) is at least 8000, preferably at least 10,000, more preferably 10,000 to 1,000,000.

The luminescent polymer having a repeating unit represented by formula (1) may be produced in the following way.

The luminescent polymer having a repeating unit represented by formula (1) may be produced by heating the polymer that has a repeating unit represented by formula (14) in an inert atmosphere, such as an atmosphere of nitrogen gas, in the presence of, for example, polyphosphoric acid or phosphorous oxychloride (POCl₃). The heating temperature is normally an appropriate temperature below the boiling point of the solvent under atmospheric pressure. Another method of producing the luminescent polymer is to heat the polymer having a repeating unit represented by formula (14) to a high temperature in a stream of an inert gas such as nitrogen gas.

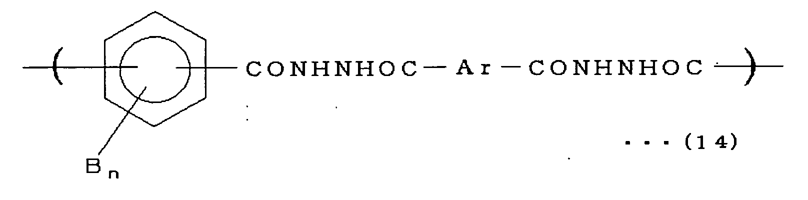

The polymer having a repeating unit represented by formula (14) may be obtained by reacting an acid halide, such as an acid chloride represented by formula (15), with a carbohydrazine represented by formula (16) in an inert atmosphere, such as an atmosphere of nitrogen gas, in a solvent such as tetrahydrofuran (THF), an ester of dimethylacetic acid (DMAc), in the presence of a dehydrohalogenating agent, such as pyridine, hexamethylphosphoric triamide, or tris(dimethylamino)-phosphine to eliminate a hydrogen halide. 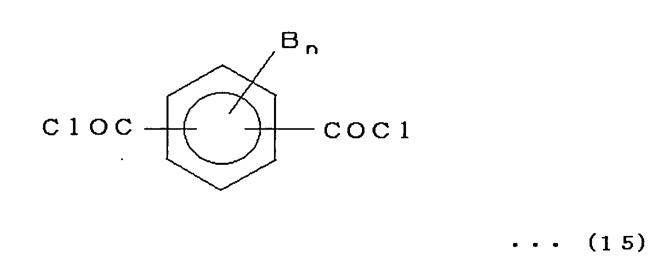 In formula (15), B and n mean the same as those as defined above. Formula (16) is:

NH₂NH―OC―Ar―CO―NHNH₂ (16)

The carbohydrazine represented by formula (16) may be produced by heating an acid halide, such as an acid chloride represented by formula (17), and hydrazine in a solvent such as THF or DMAc, in an inert atmosphere such as an atmosphere of nitrogen gas, in the presence of the dehydrohalogenating agent as mentioned above, to an appropriate high temperature up to about 120°C.

Cl―OC―Ar―CO―Cl (17)

When substituent B of Ar in an acid chloride represented by formula (17) is -O-Ar¹ or -O-R wherein Ar¹ and R are the same as those defined above, the introduction of -O-Ar¹ or -O-R can easily be done by Williamson synthesis. Williamson synthesis is a known method in which an alcoholate represented by R'OY, wherein R' is an alkyl group or an aromatic group, and Y is an alkaline metal such as sodium, is allowed to react with an alkyl halide represented by R"X, wherein R" is an alkyl group or an aromatic group and X is a halogen atom, so that an R'-O-R" mixed ether is synthesized. (See, for example, page 183 of the sixth edition of "Introduction to Organic Chemistry" written by Sei-ichi Ishikawa and Yoshimori Omote, published on February 25, 1977 by Baifukan Co., Ltd.) Since Williamson synthesis is a well-known reaction, a detailed explanation of the reaction conditions, which include the atmosphere, the solvent, the reaction temperature and the reaction time, to synthesize an acid chloride having substituent B that has an ether linkage, is omitted here.

When substituent B of Ar in the acid chloride represented by formula (17) is -Ar¹ or -R, the introduction of -Ar¹ or -R to the aromatic group can easily be done by reacting X-Ar¹ or X-R, wherein X is a halogen atom, with the phenylene group or the naphthylene group in the presence of a metal catalyst such as zinc in an inert atmosphere. Therefore a detailed explanation of the introducing step is omitted here.

The luminescent polymer having a repeating unit represented by formula (10) can easily be produced in essentially the same way as the luminescent polymer having a repeating unit represented by formula (1) . Specifically, it can be obtained by heating a polymer having a repeating unit represented by formula (18) in an inert atmosphere, such as an atmosphere of nitrogen gas, in the presence of, for example, polyphosphoric acid or phosphorous oxychloride (POCl₃). Alternatively, the luminescent polymer having a repeating unit represented by formula (10) can also be obtained by heating the polymer in a stream of an inert gas such as nitrogen gas or in an inert atmosphere such as an atmosphere of nitrogen gas under reduced pressure.

The repeating unit represented by formula (18) is: 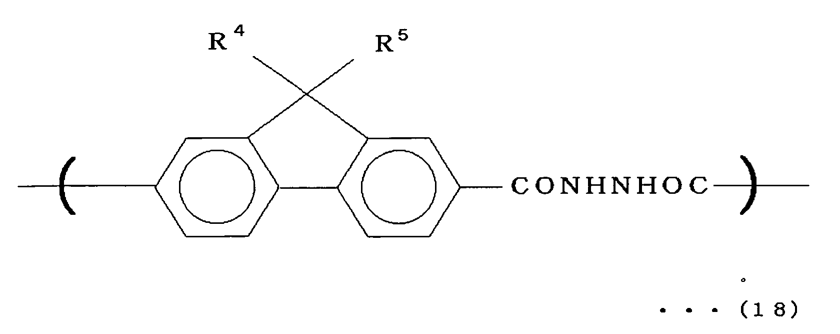 In formula (18), R⁴ and R⁵ are the same as those defined above. A polymer having the repeating unit represented by formula (18) can be produced by reacting an acid halide, such as an acid chloride represented by formula (19), with a carbohydrazine represented by formula (20) in a solvent such as tetrahydrofuran in the presence of a dehalogenating agent such as pyridine at a temperature of 60°C to the boiling temperature of the solvent.

The acid chloride represented by formula (19) is: 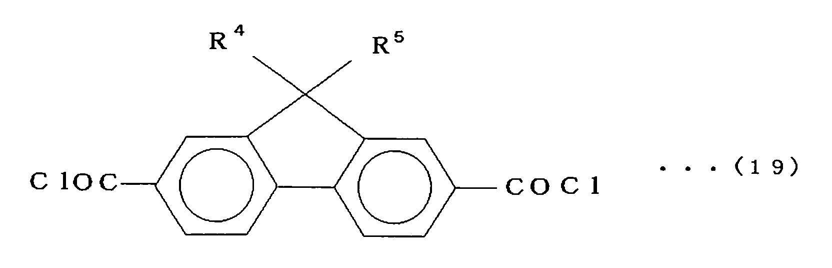 In formula (19), R⁴ and R⁵ are the same as those defined above. The acid chloride represented by formula (19) can easily be produced through the reaction between the corresponding carboxylic acid and thionyl chloride. The reaction changing a carboxylic acid to an acid chloride with thionyl chloride is well known.

The carbohydrazine represented by formula (20) is: 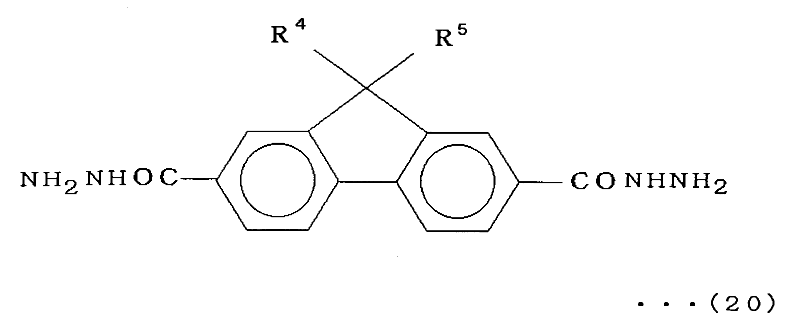 In formula (20), R⁴ and R⁵ are the same as those defined above.

The carbohydrazine represented by formula (20) can be produced by reacting an acid halide, such as an acid chloride represented by formula (19), with hydrazine in a solvent such as tetrahydrofuran in the presence of a dehalogenating agent such as pyridine at a temperature of 60°C to the boiling temperature of the solvent.

The luminescent polymers having the repeating units represented by formulas (1), (7)-(9) and (10) can be formed into a film. Sandwiching a film of the luminescent polymer between a pair of electrodes makes a luminescent element.

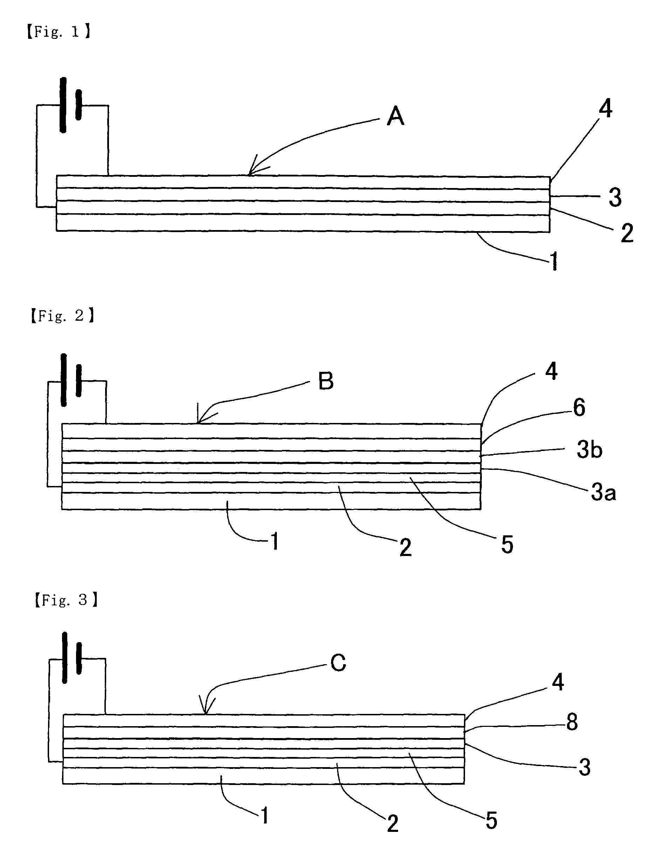

Figure 1 is a schematic illustration that shows the sectional structure of a luminescent element according to the present invention, which is a one-layer type organic EL element. As shown in this figure, the luminescent element A is prepared by layering a light-emitting layer 3, which is a film of the luminescent polymer of the present invention and an electrode layer 4 in this order on a substrate 1 with which a transparent electrode 2 has been provided.

When the luminescent element shown in Figure 1 has a film of the luminescent polymer of the present invention, the element emits light, the color of which reflects the chemical structure of the polymer, upon the application of electricity at the transparent electrode 2 and the electrode layer 4. When an electric field is applied between the transparent electrode 2 and the electrode layer 4, electrons are injected from the electrode layer 4 and positive holes are injected from the transparent electrode 2. In the light-emitting layer 3, the electrons are recombined with positive holes, which causes the energy level to return to the valence band from the conduction band. This transition of the energy level is accompanied by emission of the energy differential as light.

The luminescent element A shown in Figure 1, when it is shaped to a planar form with a large area, may be used as a planar illuminator, for example a large-area wall illuminator when fixed on a wall, or a large-area ceiling illuminator when fixed on a ceiling. This luminescent element may be utilized for a planar light source in place of a point light source, such as a conventional bulb, and a line light source, such as a conventional fluorescent lamp. In particular, this illuminator can suitably be used to light up walls, ceilings and floors in dwelling rooms, offices and passenger trains, or to make them emit light. Moreover, this luminescent element Amay be suitable for the backlight used in displays of computers, cellular phones and ATMs. Furthermore, this illuminator may be used for various light sources, such as the light source of direct illumination and that of indirect illumination. Also, it may be used for the light sources of advertisement apparatuses, road traffic sign apparatuses and light-emitting billboards, which have to emit light at night and provide good visibility. In addition, because this luminescent element A includes a luminescent polymer of the present invention in the light-emitting layer, the luminescent element A may have a long life. Therefore, light sources employing the luminescent element A will naturally have a long life.

The luminescent element Amay also be shaped into a tubular light emitter comprising a tubularly shaped substrate 1, a transparent electrode 2 placed on the inside surface of the substrate 1, a light emitting layer 3 and an electrode layer 4 placed on the transparent electrode 2 in this order. Because the luminescent element A does not include mercury, it is an ecological light source and may be a substitute for conventional fluorescent lamps.

For the substrate 1 may be used any known substrate, as long as the transparent electrode 2 can be formed on the surface of the substrate. Examples of the substrate 1 are a glass substrate, a plastic sheet, a ceramic substrate, and a metal substrate of which surface is insulated, for example, through the formation of an insulating layer thereon.

The light-emitting layer 3 may be in the shape of a film or a sheet that is made of a luminescent polymer according to the present invention.

The thickness of the light-emitting layer 3 ranges, typically between 30 nm and 500 nm, preferably between 100 nm and 300 nm. When the thickness is too small, the amount of the emitted light may be insufficient. On the other hand, when the thickness is too large, the voltage required to drive the illuminator or element may be too high, which is not desirable. Besides, the large thickness may reduce the flexibility of the film necessary to shape a planar, tubular, curved, or ring article.

The film or sheet made of a luminescent polymer according to the present invention may be formed through the application of a solution of the polymer dissolved in an appropriate solvent. The application method is one selected from a spin cast method, a coating method, a dipping method, etc. Also, the light-emitting layer 3 may be made through sandwiching a powder of a luminescent polymer according to the invention between the electrodes, melting the powder, and contact-bonding the melted powder.

For the electrode layer 4 may be employed a material having a small work function. Examples of the material are elementary metals and metallic alloys, such as MgAg, aluminum alloy, metallic calcium, etc. A preferable electrode layer 4 is made of an alloy of aluminum and a small amount of lithium. This electrode layer 4 may easily be formed on the surface of light-emitting layer 3, which, in turn, has been formed on substrate 1, by the technique of metal deposition.

When either of the application method or the melting and contact-bonding method is employed, a buffer layer should be inserted between each electrode and the light-emitting layer.

Materials for the buffer layer are, for example, an alkaline metal compound such as lithium fluoride, an alkaline earth metal compound such as magnesium fluoride, an oxide such as an aluminum oxide, and 4, 4'-biscarbazole biphenyl (Cz-TPD) . Also, materials for forming the buffer layer between the cathode made of ITO, etc. and the organic layer are, for example, m-MTDATA (4,4',4"-tris(3-methylphenyl-phenylamino)triphenylamine), phthalocyanine, polyaniline, and polythiophene derivatives, and inorganic oxides such as molybdenum oxide, ruthenium oxide, vanadium oxide and lithium fluoride. When the materials are suitably selected, these buffer layers can lower the driving voltage of the organic EL element, which is the luminescent element, improve the quantum efficiency of luminescence, and achieve an increase in the luminance of the emitted light.

Next, the second example of the luminescent element in accordance with this invention is shown in Figure 2. This figure is an illustration showing the sectional layer structure of an example of the luminescent element, which is a multi-layer organic EL element.

As shown in Figure 2, the luminescent element B comprises a substrate 1, and a transparent electrode 2, a hole-transporting layer 5, light-emitting sublayers 3a and 3b, an electron-transporting layer 6, and an electrode layer 4, the layers being laid on the substrate 1 one by one in this order.

The substrate 1, the transparent electrode 2 and the electrode layer 4 are the same as those explained for the luminescent element A in Figure 1.

The light-emitting layer of the luminescent element B comprises light-emitting sublayers 3a and 3b. The light-emitting sublayer 3a is a deposited film formed by depositing a light-emitting compound on the hole-transporting layer 5. The light-emitting sublayer 3b is a DPVBi layer, which functions as a host material.

Examples of the hole-transporting substance included in the hole-transporting layer 5 are a triphenylamine compound such as N,N'-diphenyl-N,N'-di(m-tolyl)-benzidine (TPD) and α -NPD, a hydrazon compound, a stilbene compound, a heterocyclic compound, a π electron star burst positive hole transporting substance, etc.

Examples of the electron-transporting substance included in the electron-transporting layer 6 are an oxadiazole derivative such as 2-(4-tert-butylphenyl)-5-(4-biphenylyl)-1,3,4-oxadiazole and 2,5-bis(1-naphthyl)-1,3,4-oxadiazole (BND), and2,5-bis(5'-tert-butyl-2'-benzoxazolyl) thiophene. Also, a metal complex material such as quinolinol aluminum complex (Alq3), benzoquinolinol beryllium complex (Bebq2) may be used suitably.

The electron-transporting layer 6 of the luminescent element B shown in Figure 2 includes Alq3 as electron-transporting substance.

The thickness of each layer is the same as that in a known multi-layer organic EL element.

The luminescent element B in Figure 2 functions and emits light in the same ways as the luminescent element A in Figure 1. Therefore, the luminescent element B has the same uses as the luminescent element A.

The third example of the luminescent element of this invention is shown in Figure 3. This figure is an illustration showing the sectional layer structure of an example of the luminescent element, which is a multi-layer organic EL element.

The luminescent element C shown in Figure 3 comprises a substrate 1, and a transparent electrode 2, a hole-transporting layer 5, a light-emitting layer 3, an electron-transporting layer 8, and an electrode layer 4, wherein the transparent electrode and the layers are laid on substrate 1 one by one in this order.

The luminescent element C functions in the same way as the luminescent element B.

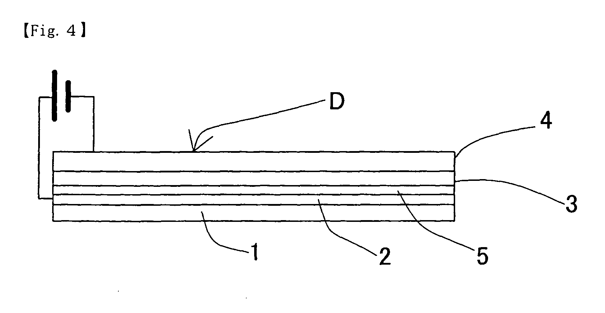

Another example of the luminescent element of this invention is shown in Figure 4. The luminescent element D comprises a substrate 1, and a transparent electrode 2, a hole-transporting layer 5, a light-emitting layer 3, and an electrode layer 4 wherein the transparent electrode and the layers are laid on the substrate 1 one by one in this order.

An example of the luminescent elements, other than those shown in Figures 1-4, is a two-layer lowmolecular weight organic luminescent element having a hole-transporting layer that includes a hole-transporting substance and an electron-transporting luminescent layer that includes a blue light-emitting element of the invention laid on the hole-transporting layer, these layers being sandwiched between a cathode, which is the transparent electrode formed on the substrate, and an anode, which is the electrode layer. A specific example of this embodiment is a two-layer pigment-injected luminescent element comprising a hole-transporting layer and a luminescent layer that includes a host pigment and a blue light-emitting polymer of this invention as a guest pigment, wherein the luminescent layer is laid on the hole-transporting layer and these layers are sandwiched between the cathode and the anode. Another example is a two-layer organic luminescent element comprising a hole-transporting layer that includes a hole-transporting substance and an electron-transporting luminescent layer that is prepared through a co-deposition of a blue light-emitting polymer of the invention and an electron-transporting substance, the latter layer being laid on the former, and these two layers being sandwiched between the cathode and the anode. A specific example of the second embodiment is a two-layer pigment-injected luminescent element comprising a hole-transporting layer and an electron-transporting luminescent layer that includes a host pigment and a blue light-emitting polymer of this invention as a guest pigment, wherein the luminescent layer is laid on the hole-transporting layer and these layers are sandwiched between the cathode and the anode. A further example is a three-layer organic luminescent element comprising a hole-transporting layer, a luminescent layer including a blue light-emitting polymer of this invention that is laid on the hole-transporting layer, and an electron-transporting layer that is laid on the luminescent layer, these layers being sandwiched between the cathode and the anode.

Also, it is preferred if the luminescent layer includes, as a sensitizing agent, rubrene, especially both of rubrene and A1q3.

A luminescent element utilizing a luminescent polymer of this invention may generally be used for an organic EL element driven by direct current, and also by pulses and alternating current.

### Examples

### (Working Example 1)

The acid chloride represented by formula (b) and the carbohydrazine represented by formula (c) were synthesized in the following steps in accordance with Reaction Process 1 below.

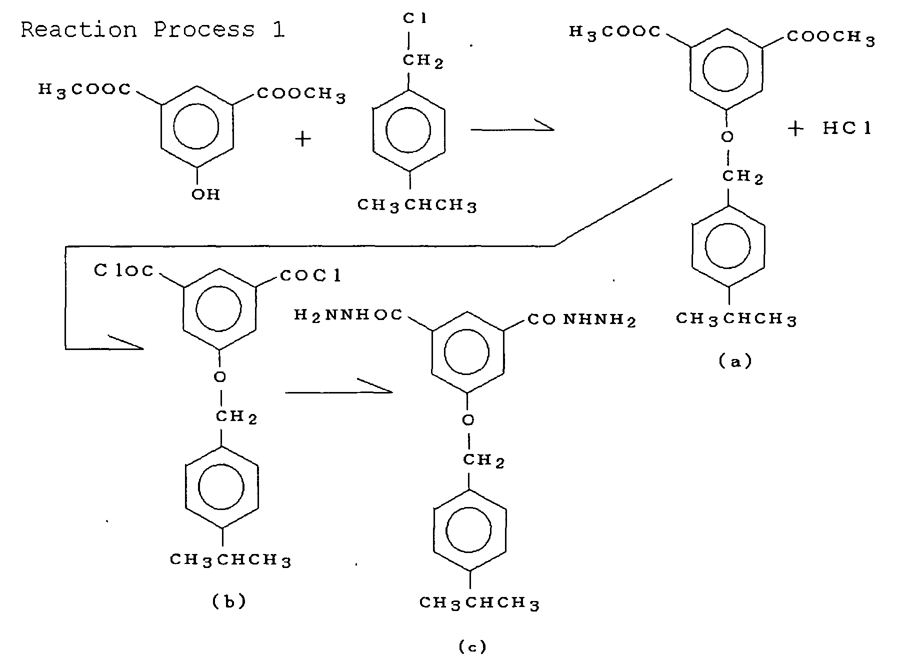

25 g of dimethyl 5-hydroxyisophthalate, 40.1 g of 4-isopropylbenzyl chloride, and 98.6 g of potassium carbonate were added to 300 ml of cyclohexanone. The obtained mixture was stirredunder reflux at 160°C for 13 hours. Then, the product was cooled naturally. 600 ml of water and 500 ml of diethyl ether were added to the cooled product, which divided the obtained into an oil phase and a water phase. The oil phase was taken.

In order to wash and neutralize the separated oily liquid, 250 ml of a 15% aqueous solution of sodium hydroxide was added to the oily liquid. Then, the oil phase was again separated by liquid-liquid separation. The separated oily liquid was washed with water, and dried over anhydrous sodium sulfate. The dried liquid was subjected to filtration. The filtrate was taken.

The solvent was distilled off the filtrate with an evaporator. The remaining was dried at 100°C for 2 hours under reduced pressure produced with a vacuum pump. Then, the dried was dissolved in 70 ml of petroleum ether, and the obtained solution was heated, cooled naturally and recrystallized.

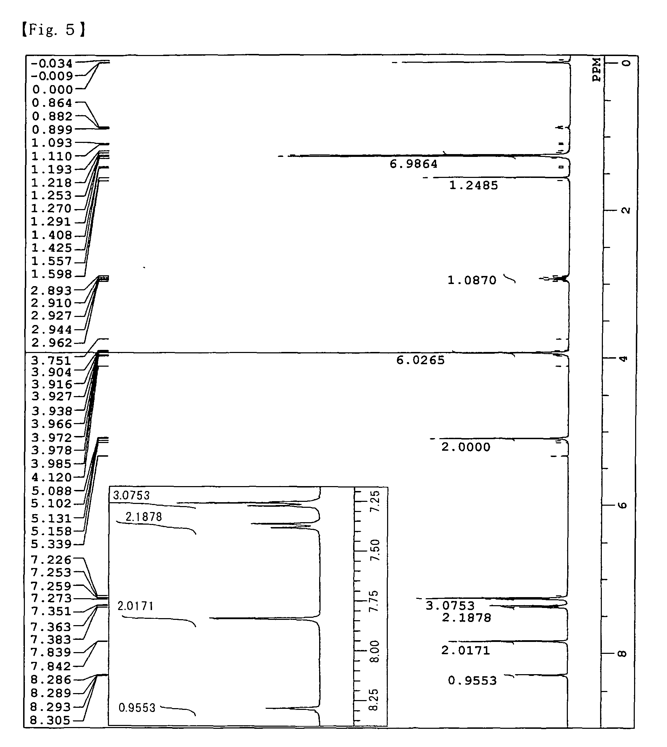

Solids obtained through the recrystallization were dried, and 14.8 g of compound (a) was obtained in a 34.9% yield. The compound was identified based on the NMR chart shown in Figure 5.

10 g of compound (a) and 20 ml of a 40% aqueous solution of sodium hydroxide were added to 60 ml of 1,4-dioxane. The obtained mixture was stirred under reflux at 110°C for 3 hours.

The product liquid was cooled with ice, and the pH value thereof was adjusted to 3 with hydrochloric acid. The product liquid acidic with hydrochloric acid was filtered and solids were taken. The solids were washed with water and ethyl ether in this order, and dried. 8.20 g of a solid matter was obtained.

In 50 ml of 1, 4-dioxane were dissolved 8.2 g of the obtained solid matter and 38.1 ml of thionyl chloride. The obtained solution was stirred under reflux at 110°C for 3.5 hours. After the product was cooled naturally, 1,4-dioxane and thionyl chloride were distilled away under reduced pressure. To the remaining was added 100 ml of tetrahydrofuran, which may sometimes be abbreviated to "THF" hereinafter. The obtained solution was filtered, and THF was removed from the filtrate with an evaporator. The essence was dried at 70°C for 10 minutes under reduced pressure produced with a vacuum pump. 8.7 g of an acid chloride, which was compound (b) in Reaction Process 1 above, was obtained.

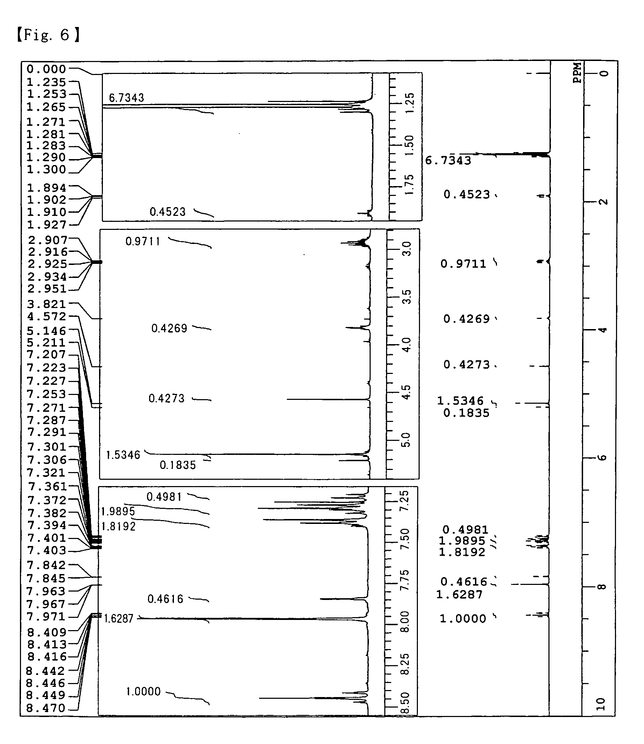

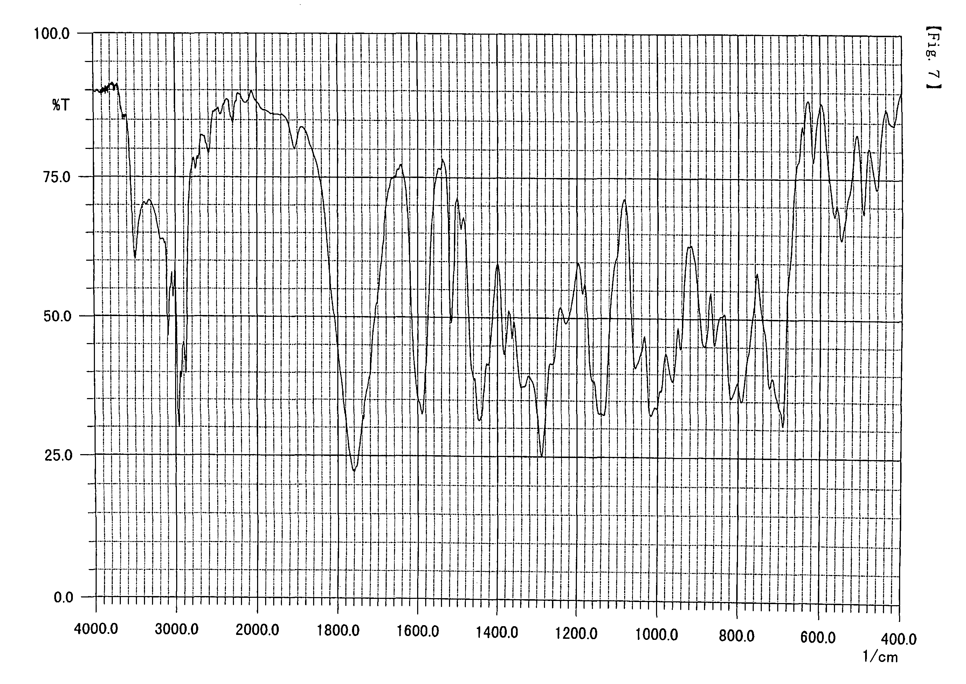

The acid chloride obtained was identified based on the NMR chart shown in Figure 6 and the IR chart shown in Figure 7.

1.76 g of pyridine, 10 g of anhydrous hydrazine, and 3.9 g of the obtained acid chloride (b) were mixed, and the temperature of the mixture was brought to room temperature. Then, the mixture was stirred at 50°C for 24 hours. After cooled naturally, the product liquid was introduced into ice water, which made solids precipitate out. The precipitate was separated by filtration, washed with water and methanol in this order, and dried. 1.1 g of a skin-colored solid matter was obtained.

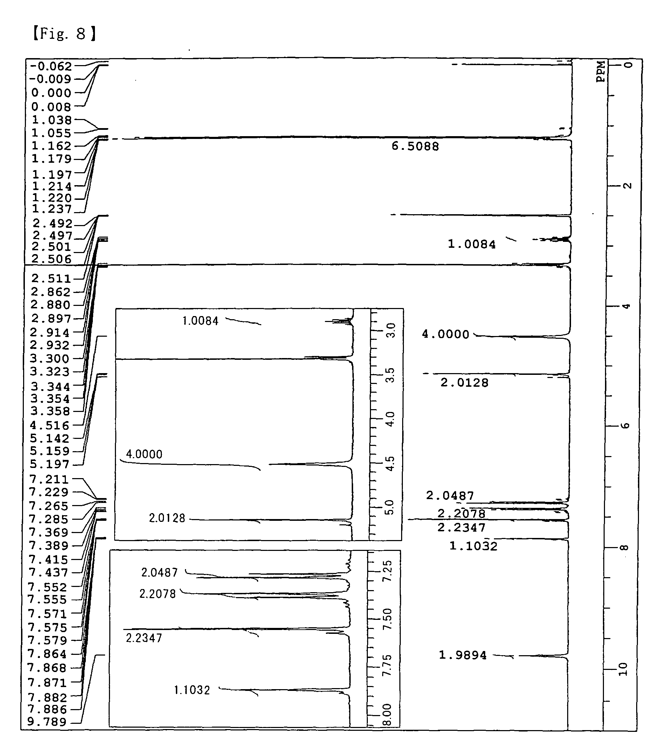

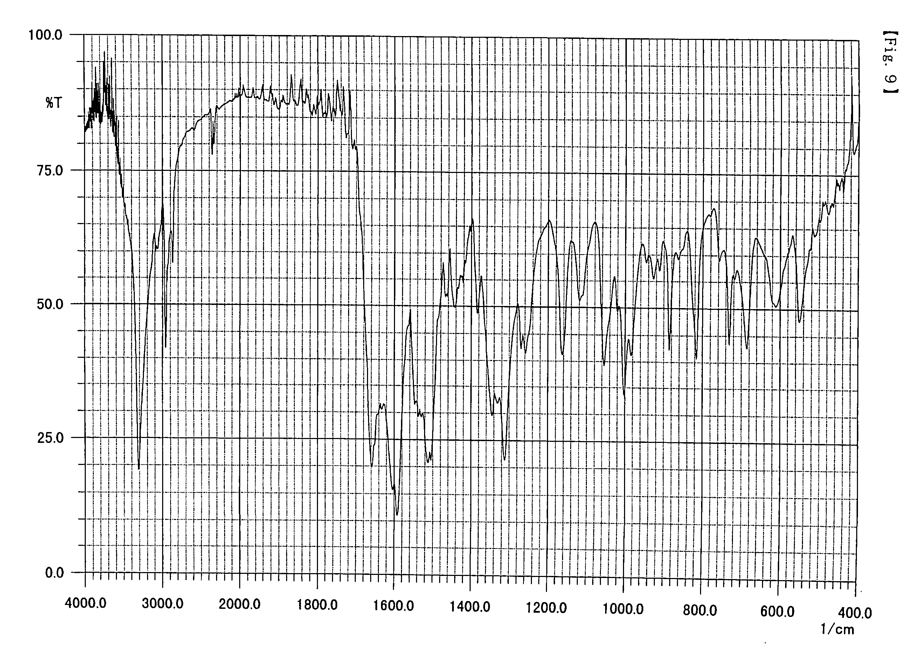

The skin-colored solid matter was identified as the compound having the structure of formula (c) based on the NMR chart shown in Figure 8 and the IR chart shown in Figure 9.

1.44 g of the polymer having the repeating unit of formula (d) was obtained by reacting equimolar amounts of acid chloride (b) and carbohydrazine (c) in the presence of tris(dimethylamino)phosphine at temperatures of 0 to 15°C, in accordance with Reaction Process 2 below.

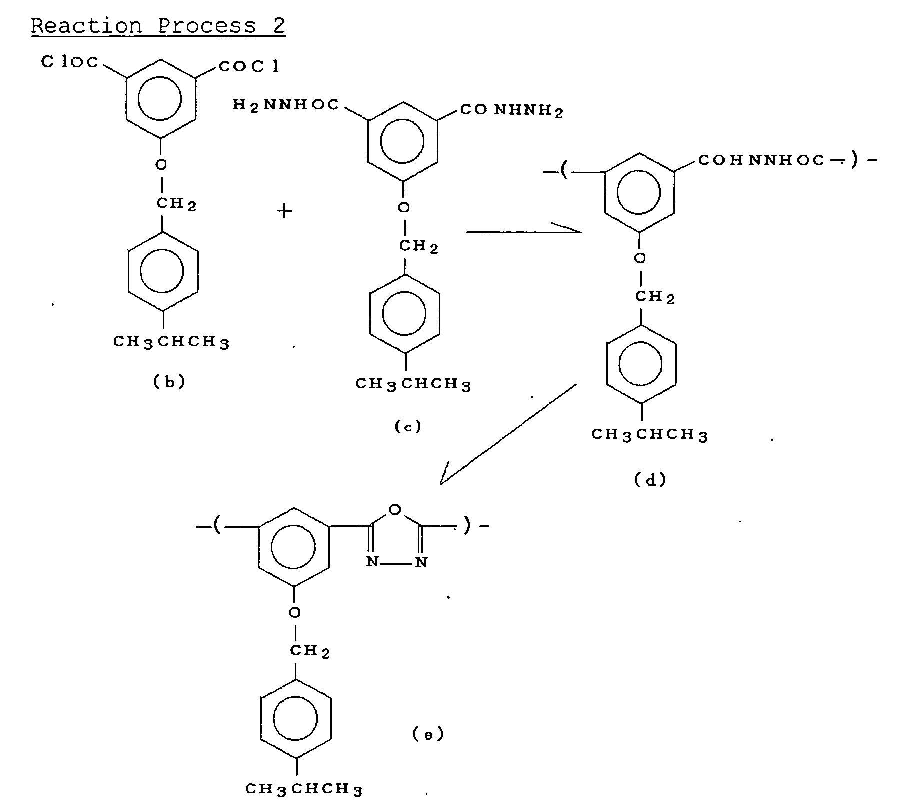

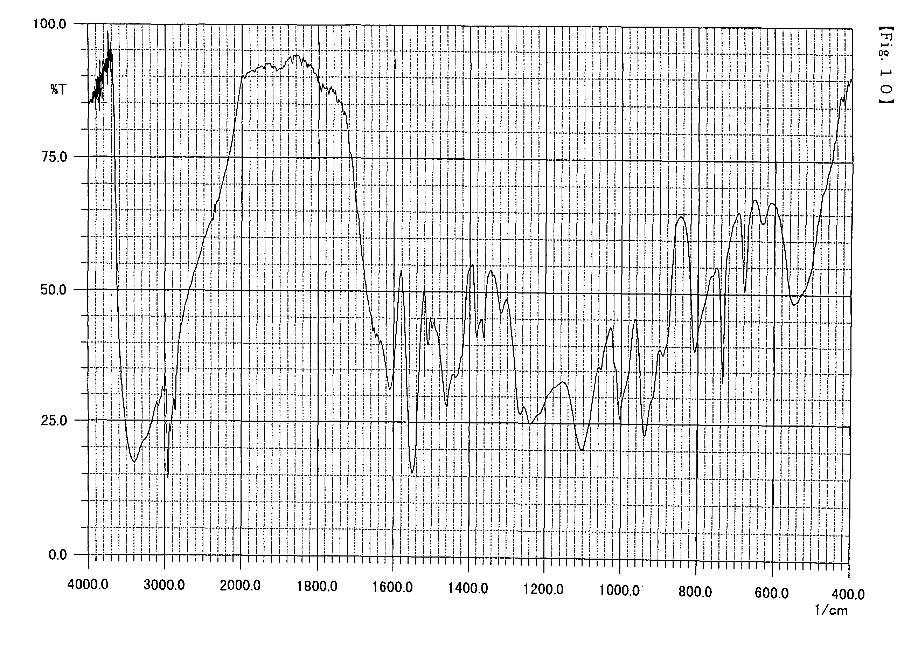

1 g of the polymer having the repeating unit represented by formula (d) was dehydrated by heating in polyphosphoric acid at 120 °c for 3.5 hours. After the completion of the dehydration, the product liquid was introduced into ice water. The obtained was filtered with suction. Solids were separated. The solids were dried in vacuo, and 0.47 g of a polymer was obtained. The IR spectrum chart shown in Figure 10 confirmed that the polymer had the repeating unit represented by formula (e).

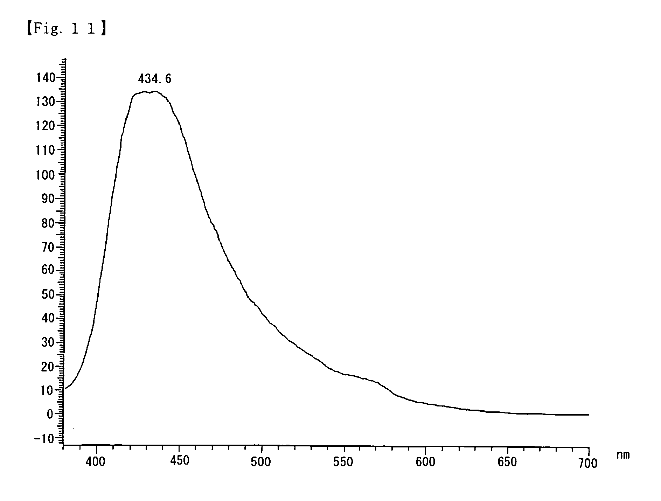

Also, the fluorescence spectrum chart in Figure 11 showed that the polymer having the repeating unit represented by formula (e) was a luminescent polymer.

### (Working Example 2)

In accordance with Reaction Process 3 below, equimolar amounts of phenyl-1,4-dicarbohydrazide and acid chloride (b) that had been prepared in the same way as in Working Example 1 in the presence of pyridine were heated and allowed to react. A polymer having the repeating unit represented by formula (d1) was obtained.

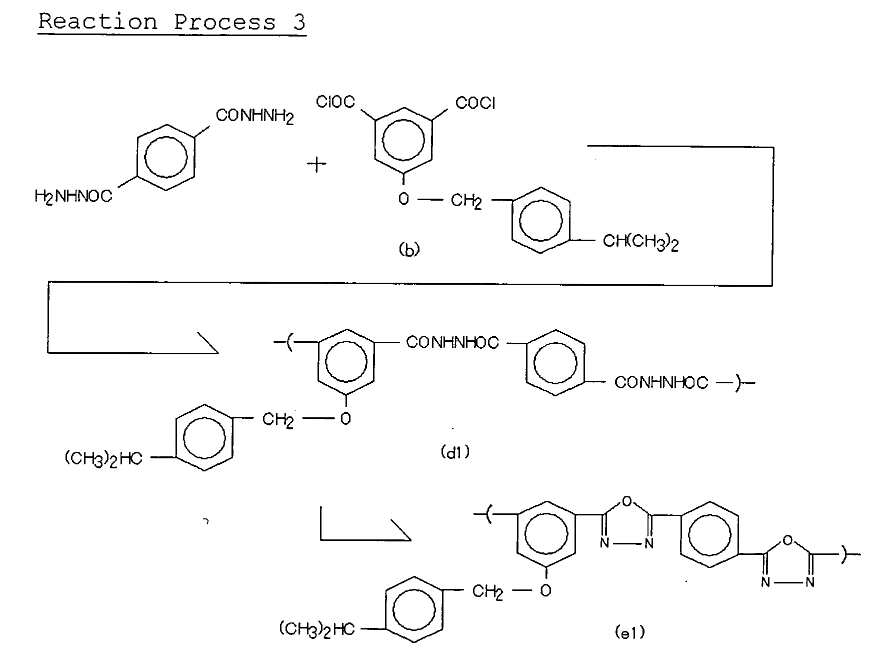

1 g of this polymer, having the repeating unit represented by formula (d1), was mixed with 25 g of polyphosphoric acid, and heated at 110°C for 4 hours to be subjected to dehydration. After the termination of the reaction, the product liquid was introduced into ice water. The obtained was filtered with suction. Solids were taken. The solids were dried in vacuo, and 0.11 g of a polymer was obtained. The IR spectrum chart shown in Figure 1 confirmed that the polymer had the repeating unit represented by formula (e1).

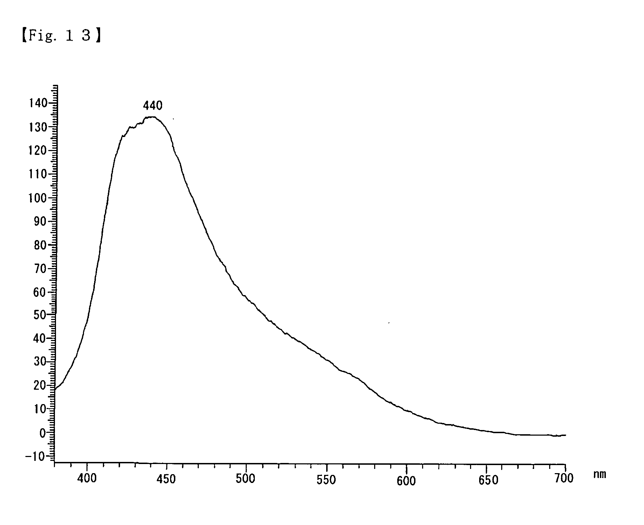

Also, the fluorescence spectrum chart in Figure 13 showed that the polymer having the repeating unit represented by formula (e1) was a luminescent polymer.

### (Working Example 3)

In accordance with Reaction Process 4 below, a polymer having the repeating unit represented by formula (e2) was synthesized.

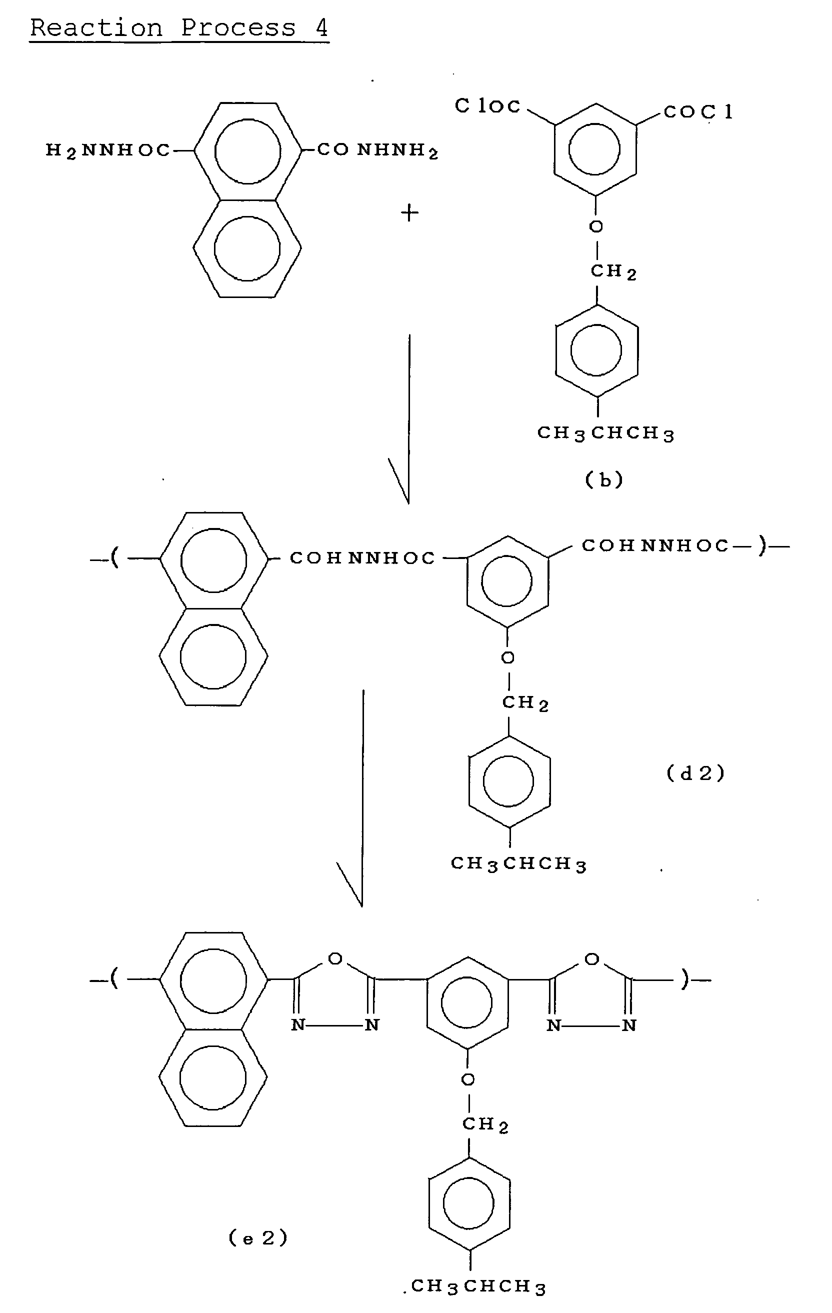

To a mixture of 40 ml of N,N-dimethylacetamide, which may sometimes be abbreviated to "DMAC" hereinafter, 2.7 g of naphthalene-1,4-dicarbohydrazide, and 3.9 g of acid chloride (c) that had been prepared in the same way as in Working Example 1 was dripped a solution of 1.99 g of hexamethylphosphoric triamide ([(CH₃)₂N]₃PO) dissolved in 40 ml of DMAC, while the mixture was being cooled with ice. Then, the reaction product was neutralized with a 20% aqueous solution of sodium hydroxide. The neutralized was filtered and solids were taken. The solids were washed with water and methanol in this order, and dried. 2.68 g of ocherous powder, which was a polymer having the repeating unit represented by formula (d2), was obtained.

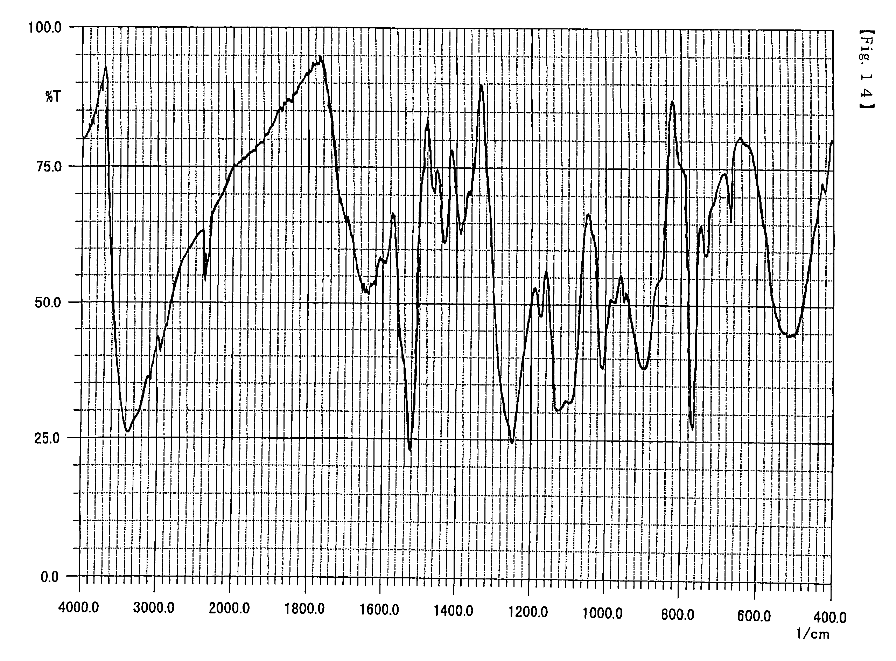

The polymer having the repeating unit represented by formula (d2) was dehydrated by heating in polyphosphoric acid at 60 to 130°C. This dehydration quickly turned the polymer to a polymer having the repeating unit represented by formula (e2) . The IR spectrum chart shown in Figure 14 confirmed that the polymer had the repeating unit represented by formula (e2) .

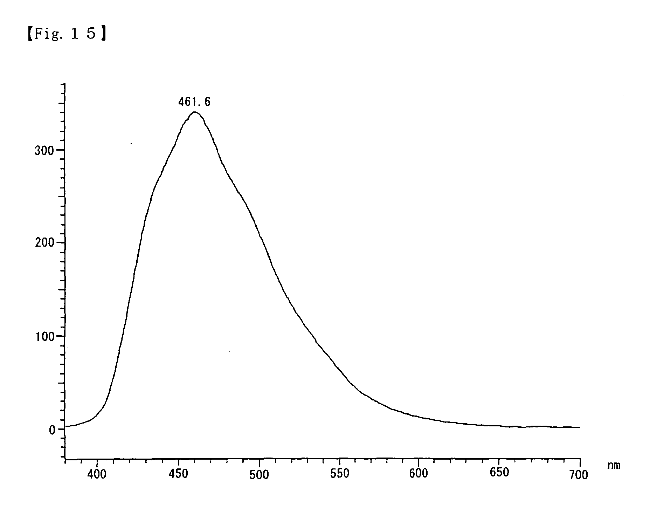

Also, the fluorescence spectrum chart in Figure 15 showed that the polymer having the repeating unit represented by formula (e2) was a luminescent polymer.

### (Working Example 4)

In accordance with Reaction Process 5 below, a polymer having the repeating unit represented by formula (e3) was synthesized.

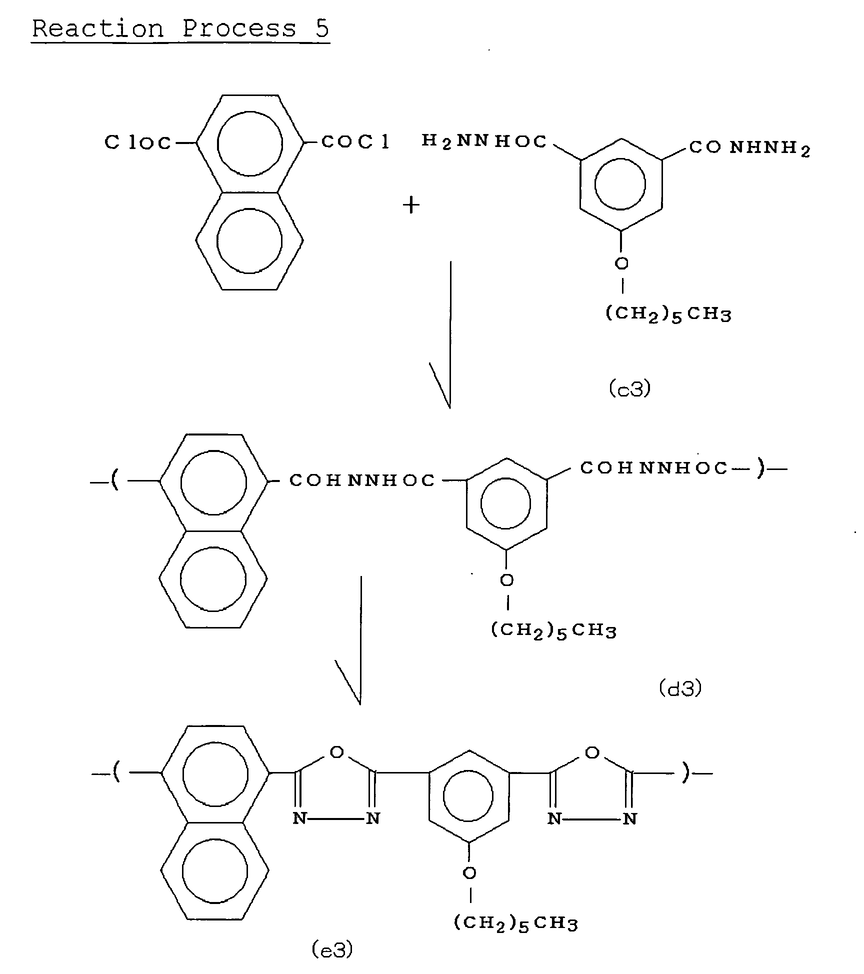

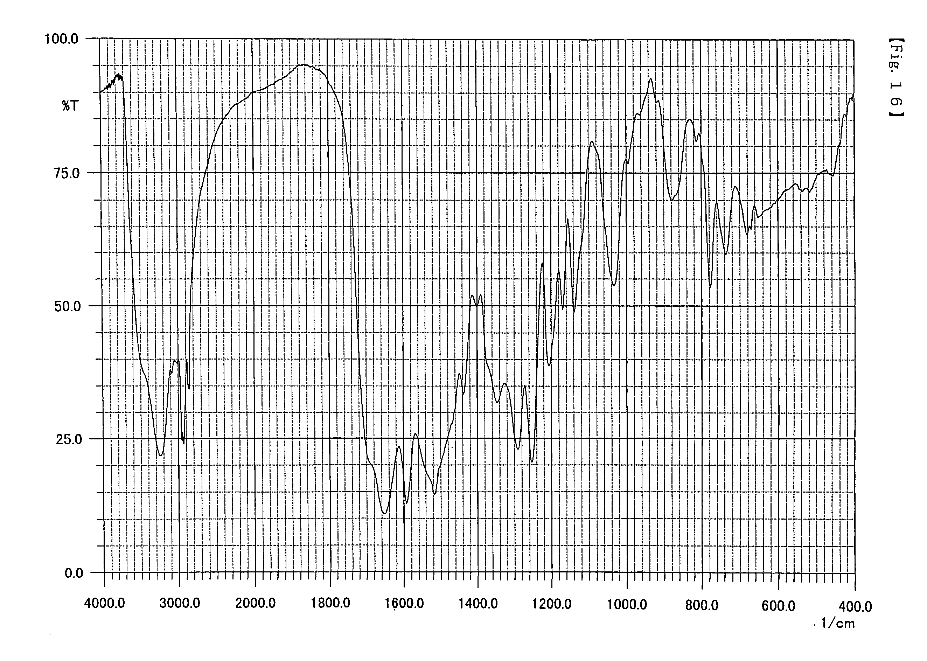

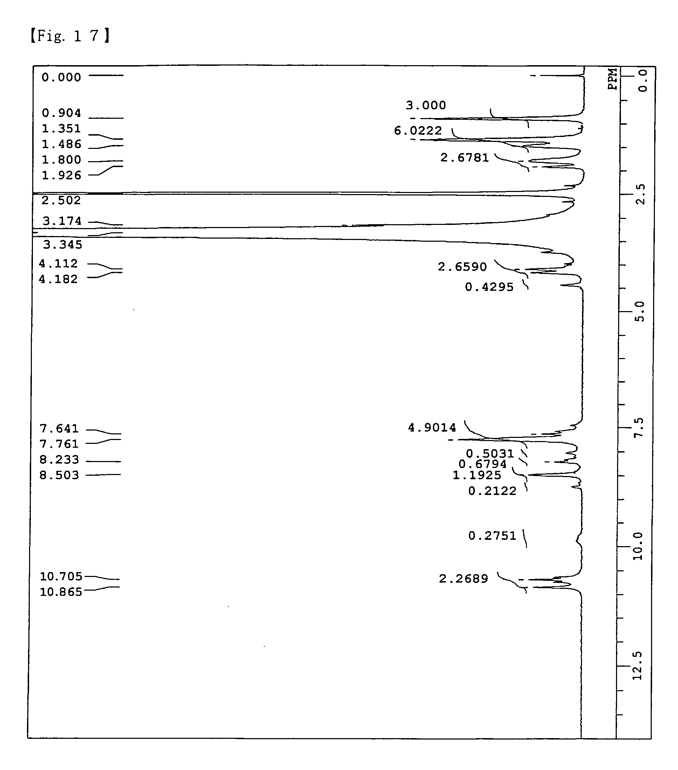

20 ml of DMAC, 0.86 g of 1,4-naphthaloyl dichloride (an acid chloride), 1 g of the carbohydrazine represented by formula (c3), and 0.6 g of hexamethylphosphric triamide ([(CH₃)₂N]₃PO) were mixed. The mixture was neutralized with a 20% aqueous solution of sodium hydroxide and filtered. Solids were taken. The solids were washed with water and methanol in this order, and dried. 0.5 g of powder was obtained. The IR spectrum chart shown in Figure 16 and the NMR spectrum chart shown in Figure 17 confirmed that the powder was a polymer having the repeating unit represented by formula (d3).

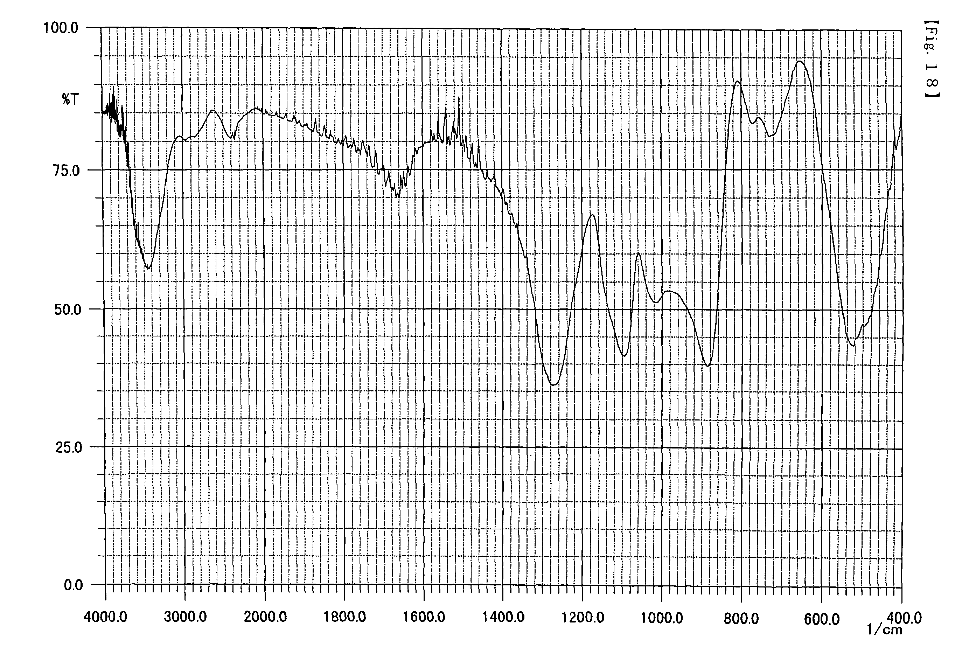

0.4 g of the polymer having the repeating unit represented by formula (d3) was dehydrated by heating in the presence of 20 g of polyphosphoric acid at 110°C for 6 hours. After the completion of the dehydration, the product liquid was introduced intoicewater. The obtained was filtered with suction. Solids were taken. The solids were dried in vacuo, and 0.1 g of a polymer was obtained. The IR spectrum chart shown in Figure 18 confirmed that the polymer had the repeating unit represented by formula (e3).

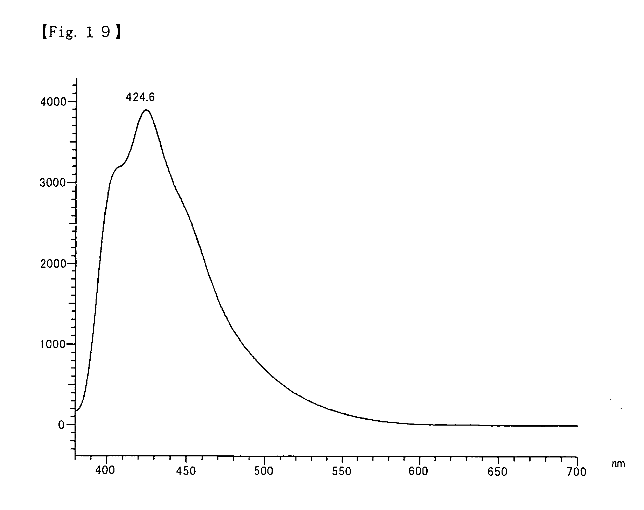

Also, the fluorescence spectrum chart in Figure 19 showed that the polymer having the repeating unit represented by formula (e3) was a luminescent polymer.

### (Working Example 5)

In accordance with Reaction Process 6 below, a polymer having the repeating unit represented by formula (e6) was synthesized.

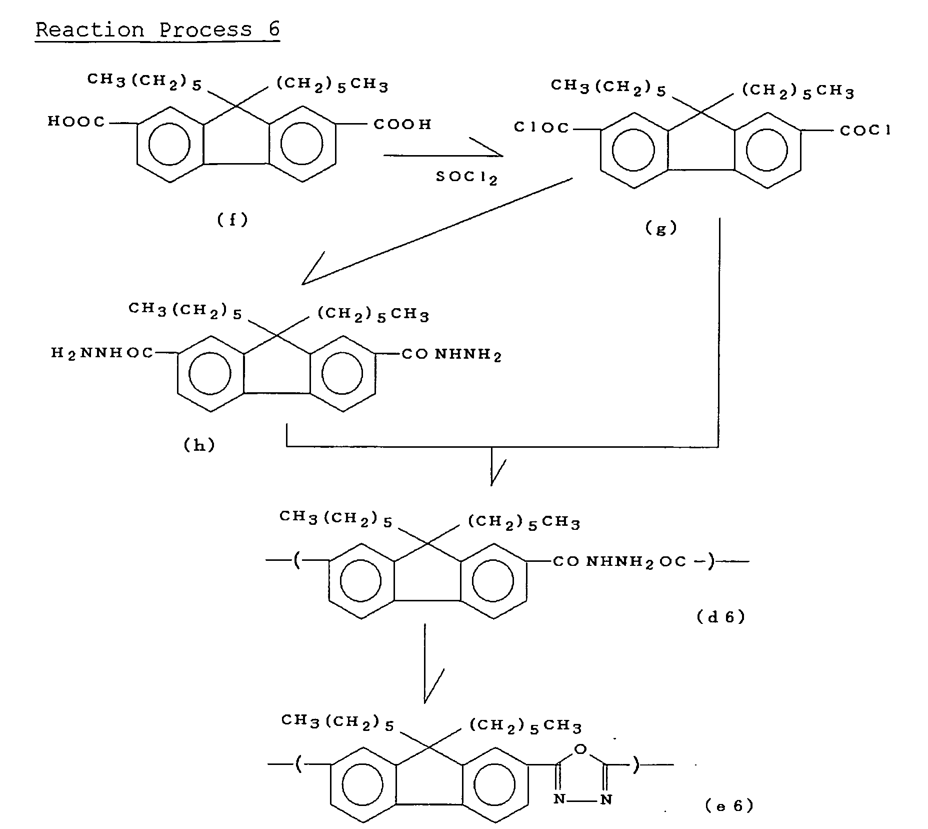

To 30 ml of thionyl chloride was added 2.25 g of 9,9-dihexyl-2,7-dihydroxycarbonylfluorene, which is compound (f) in Reaction Process 6. The obtained solution was stirred under reflux at 100°C for 2 hours. The product was cooled naturally, and then subjected to filtration. Solids were taken, and dried. The solids were dissolved in 30 ml of THF, and the obtained solution was distilled at 80°C for 50 minutes. The essence was naturally cooled and filtered. The solids were taken and dried. 2.0 g of an acid chloride, which corresponds to compound (g) in Reaction Process 6, was obtained.

To a solution of 0.22 g of pyridine and 5.5 g of hydrazine was dripped another solution of 0.5 g of the obtained acid chloride dissolved in 20 ml of THF, while the former solution was being cooled with ice. Then, the mixed solutions were heated at 75°C for 2 hours, cooled naturally, and filtered. Solids were taken and dissolved in 300 ml of DMAC. 50 g of sodium sulfate was added to the obtained solution.

The solution with the sodium sulfate was filtered, and the filtrate was distilled at 90°C for 30 minutes. 0.35 g of a carbohydrazine, which corresponds to compound (h) in Reaction Process 6, was obtained.

To a solution of 0.14 g of pyridine and 0.35 g of compound (h) dissolved in 15 ml of THF was dripped another solution of 0.36 g of the acid chloride, which was compound (g) dissolved in 15 ml of THF, while the former solution was being cooled with ice. Then, mixed solutions were heated at 80 °C for 1 hour. The resultant was cooled with ice and filtered. The solids were dried, and 0.84 g of a compound was obtained.

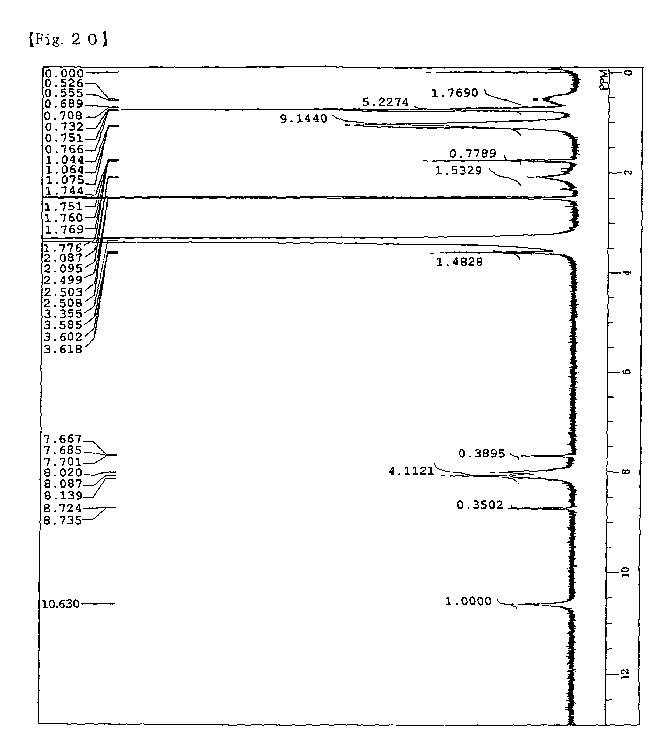

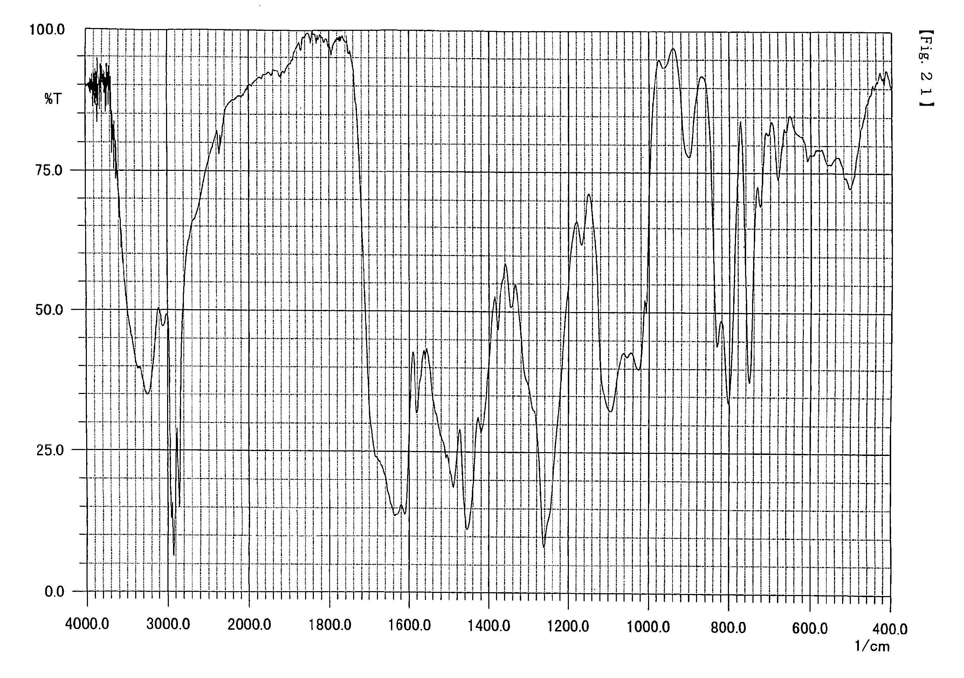

The NMR spectrum chart shown in Figure 20 and the IR spectrum chart shown in Figure 21 confirmed that the compound was a polymer having the repeating unit represented by formula (d6).

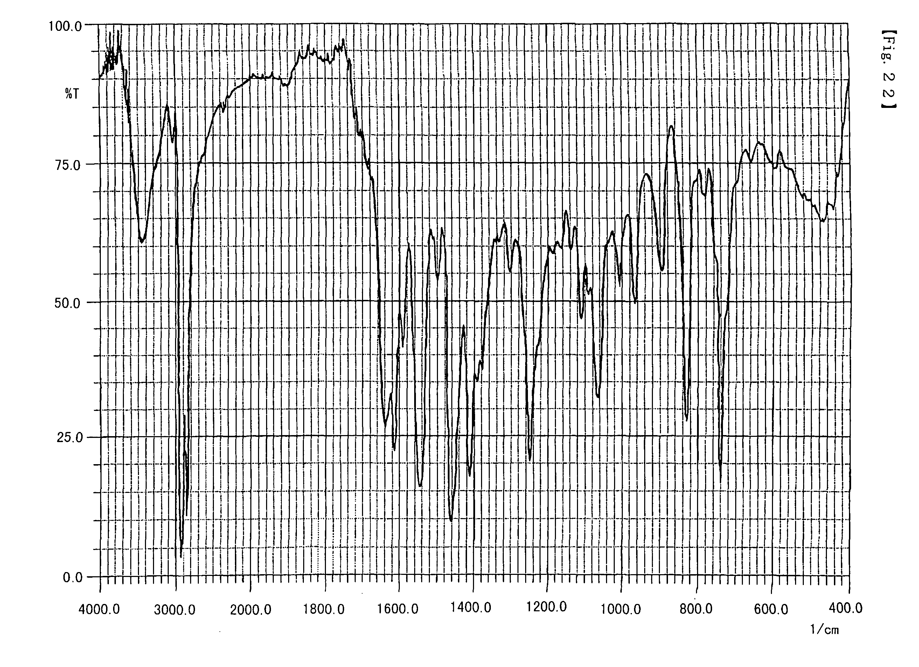

Then 0.21 g of the polymer having the repeating unit represented by formula (d6) was added to 22 g of polyphosphoric acid. The obtained solution was heated at 120°C for 13.5 hours, and then cooled and filtered. A 15% aqueous solution was added to the filtrate to neutralize it. The neutralized was filtered again and solids were taken. The solids were dried, and 0.88 g of beige powder was obtained. The IR spectrum chart shown in Figure 22 confirmed that this beige powder was a polymer having the repeating unit represented by formula (e6).

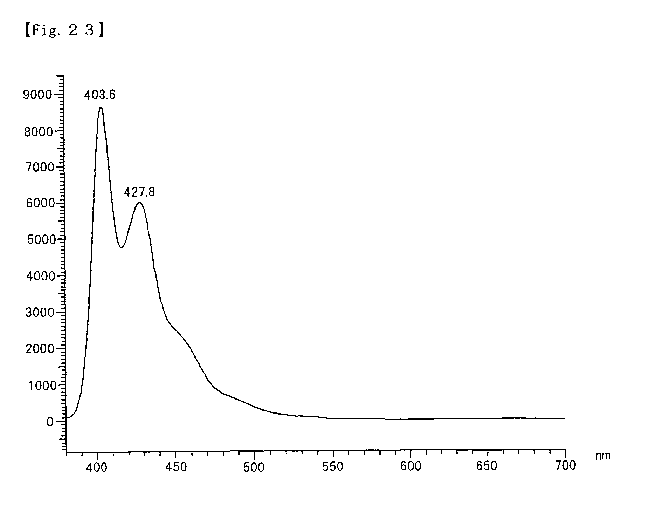

Also, the fluorescence spectrum chart in Figure 23 showed that the polymer having the repeating unit represented by formula (e6) was a luminescent polymer.

### (Working Example 6)

The carbohydrazine represented by formula (d7) was synthesized in the following steps in accordance with Reaction Process 7 below.

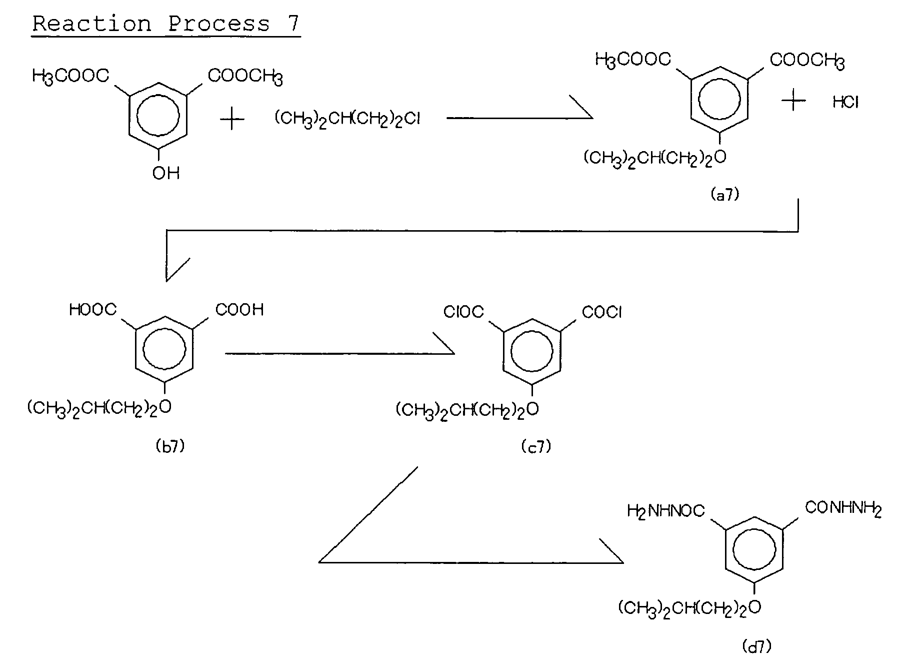

50.7 g of 1-chloro-3-methylbutane, 50 g of dimethyl 5-hydroxyisophthalate, and 163.4 g of potassium carbonate were added to 300 ml of cyclohexanone. The obtained mixture was stirred under reflux at 160°C to 170°C for 4 hours. Then, the product was cooled naturally. 300 ml of water and 200 ml of diethyl ether were added to the cooled product, which divided the obtained into an oil phase and a water phase. The oil phase was separated from the water phase.

In order to wash and neutralize the separated oily liquid, 250 ml of a 15% aqueous solution of sodium hydroxide was added to the oily liquid. Then, the oil phase was again separated by liquid-liquid separation. The separated oily liquid was washed with water, and dried over anhydrous sodium sulfate. After moisture in the liquid was removed, the dried liquid was subjected to filtration. The filtrate was taken. The solvent was distilled off the filtrate, and 62.6 g of a compound, which was compound (a7), was obtained.

60 g of compound (a7) and 20 ml of a 40% aqueous solution of sodium hydroxide were added to 100 ml of 1,4-dioxane. The obtained mixture was stirred under reflux at 105 °C for 15 hours.

The product liquid was cooled with ice, and the pH value thereof was adjusted to 4 with hydrochloric acid. The product liquid acidic with hydrochloric acid was filtered and solids were taken. After the solids were washed with water, the washed solids were redissolved in acetone. Then, the solution was filtered with suction. 19 g of dicarboxylic acid (b7) was obtained.

In 40 ml of 1,4-dioxane were dissolved 9. 5 g of obtained dicarboxylic acid (b7) and 100 ml of thionyl chloride. The obtained solution was stirred under reflux at 75 °C for 1.5 hours. After the product was cooled naturally, 1, 4-dioxane and thionyl chloride were distilled away under reduced pressure. To the remaining was added tetrahydrofuran, which may sometimes be abbreviated to "THF" hereinafter. The obtained was filtered, and THF was removed from the filtrate with an evaporator. The essence was dried at 60°C for 1 hour under reduced pressure produced with a vacuum pump. Acid chloride (c7) was obtained.

3.1 g of pyridine, 31 g of anhydrous hydrazine, 20 ml of THF, and 5.72 g of obtained acid chloride (c7) were mixed, and the temperature of the mixture was brought to room temperature. Then, the mixture was stirred at 50°C for 15.5 hours. After cooled naturally, the product liquid was introduced into ice water, which made solids precipitate out. The precipitate was separated by filtration, washed with water and dissolved in methanol. The obtained was filtered with a glass filter and the filtrate was taken. Moisture in the filtrate was removed with sodium sulfate. Then, the solvent was distilled off the filtrate, and the essence was dried. 0.7 g of a white solid matter, which was carbohydrazine (d7), was obtained.

In accordance with Reaction Process 8 below, a polymer having the repeating unit of formula (e7) was obtained by reacting equimolar amounts of 1,4-naphthaloyl dichloride and carbohydrazine (d7) in the presenceof N,N-dimethylacetaminde, which may sometimes be abbreviated to "DMAC" hereinafater, at 70°C in the following steps.

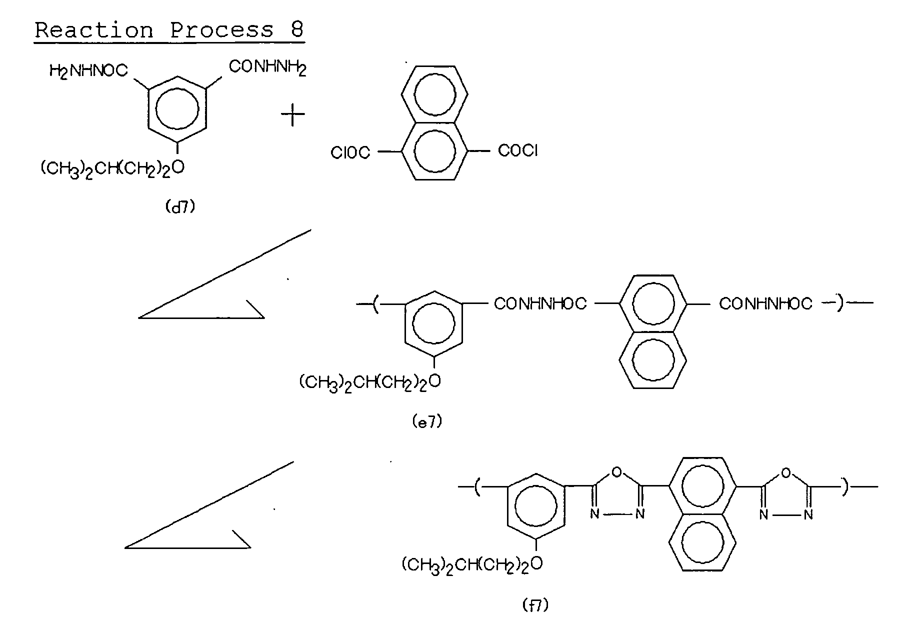

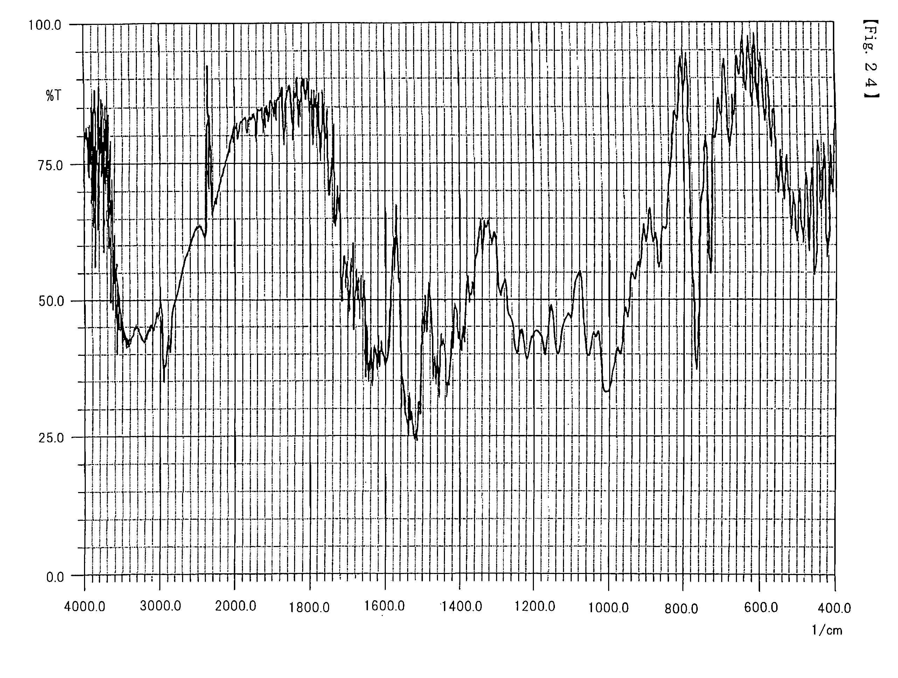

0.1 g of the polymer having the repeating unit represented by formula (e7) was reacted in nitrogen atmosphere under a pressure of 0.01 Pa at 300°C for 5 minutes. 0.01 g of a polymer was obtained. The IR spectrum chart shown in Figure 24 confirmed that the polymer had the repeating unit represented by formula (f7).

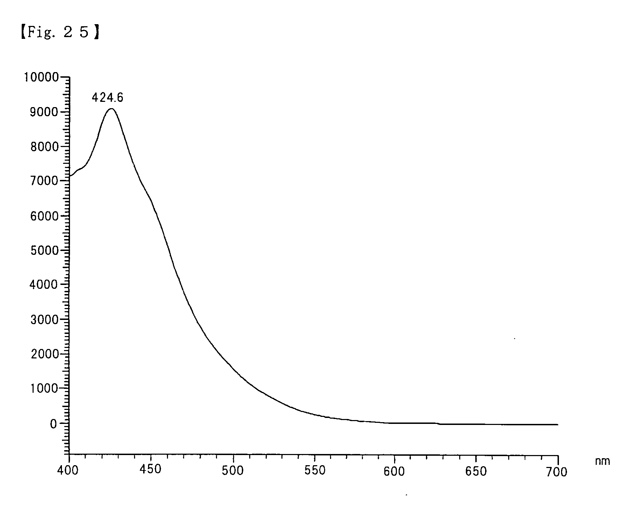

Also, the fluorescence spectrum chart in Figure 25 showed that the polymer having the repeating unit represented by formula (f7) was a luminescent polymer.

### (Working Example 7)

A polymer represented by formula (d8) was synthesized in the following steps by Reaction Process 9 below.

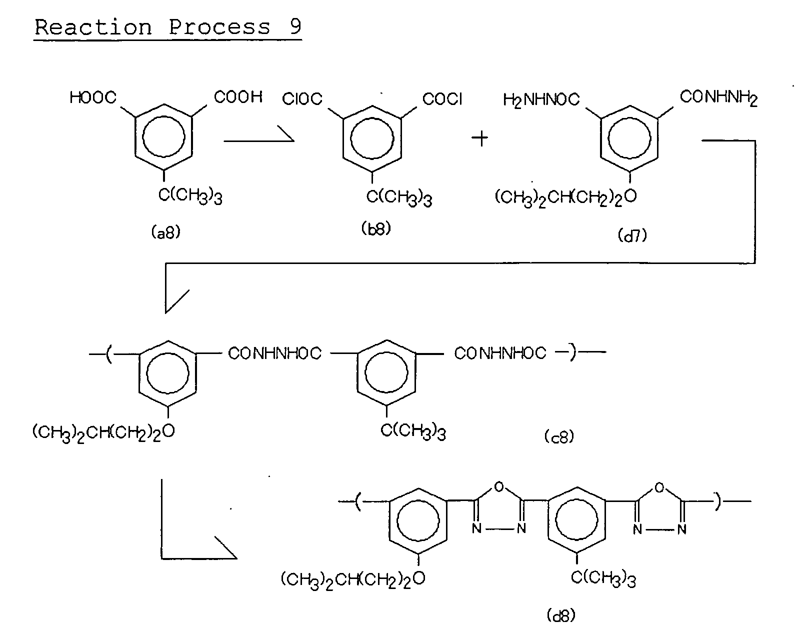

To 50 ml of 1,4-dioxane were added 18.7 g of 5-tert-butylisophthalic acid (a8) and 68 ml of thionyl chloride. The obtained solution was stirred under reflux at 80°C for 15.5 hours. After the product was cooled naturally, 1,4-dioxane and thionyl chloride were distilled away under reduced pressure . To the remaining was added tetrahydrofuran (THF) . The obtained solution was filtered and the filtrate was taken. THF was removed from the filtrate with an evaporator. Then, the essence was dried. 17.8 g of acid chloride (b8) was obtained.

20 g of pyridine, 0.37 g of acid chloride (b8), 0.4 g of carbohydrazine (d7) prepared in Working Example 6, 0.5 mg of lithium chloride, and 0.44 g of triphenyl phosphite were mixed, and the temperature of the mixture was brought to room temperature. Then, the mixture was stirred at 70 °C for 20 hours. After the product liquid was cooled naturally, the solvent was distilled away. The essence was dried. 1.23 g of a polymer having the repeating unit represented by formula (c8) was obtained.

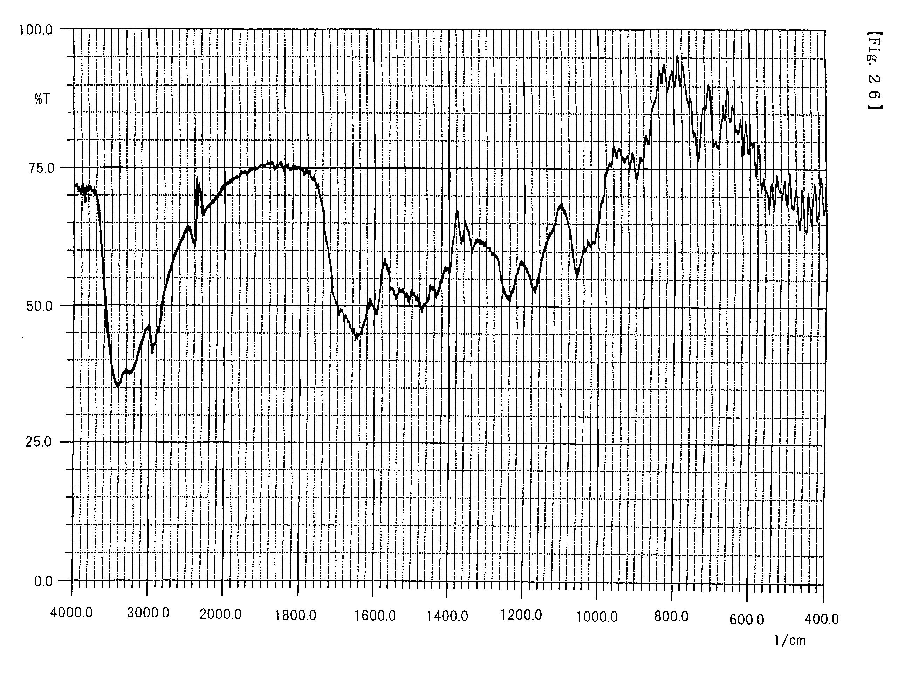

1 g of the polymer having the repeating unit (c8) was reacted in nitrogen atmosphere under a pressure of 0.01 Pa at 300°C for 5 minutes. 0.1 g of a polymer was obtained. The IR spectrum chart shown in Figure 26 confirmed that the polymer had the repeating unit represented by formula (d8).

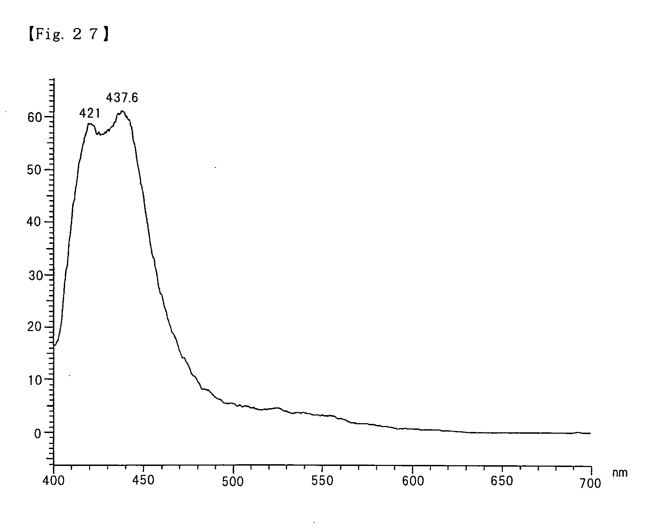

Also, the fluorescence spectrum chart in Figure 27 showed that the polymer having the repeating unit represented by formula (d8) was a luminescent polymer.

### (Working Example 8)

A polymer represented by formula (b9) was synthesized in the following steps by Reaction Process 10 below.

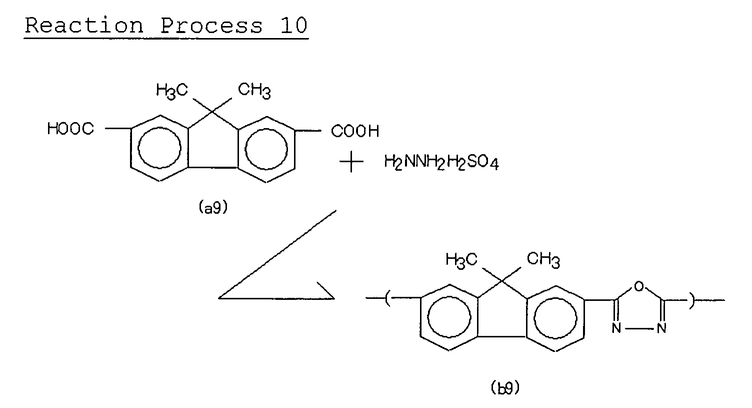

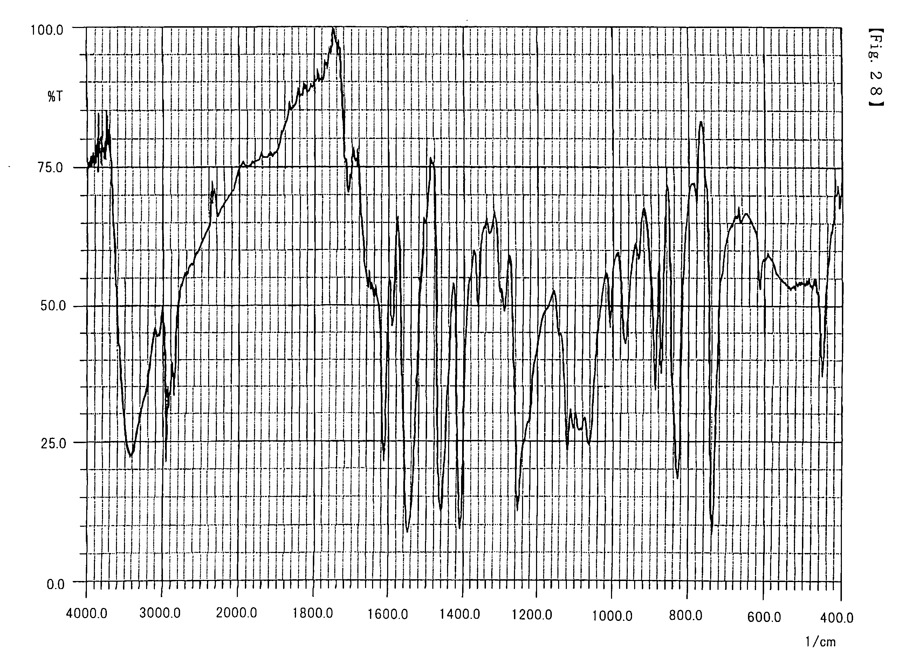

In a 50 ml three-necked flask were placed 1.40 g of 9,9'-dimethyl-2,7-dihydroxycabonylfluorene, which was compound (a9) in Reaction Process 10 above, 0.647 g of hydrazine sulfate, and 7.4 g of a polyphosphoric acid. The solution in the flask was heated to 100°C, and allowed to react for 3 hours. After the completion of the reaction, the contents in the flask were cooled with ice. The cooled contents were neutralized by adding a 10% aqueous solution of sodium hydroxide. The neutralized contents were subjected to centrifugation. Sediment was obtained and taken out. The sediment was mixed with 450 ml of water. The mixture was again subjected to centrifugation and sediment was again taken out. The sediment was mixed with 25 ml of methanol. Again, the mixture was subjected to centrifugal filtration, and the sediment was dried. 1.10 g of a polymer was obtained. The IR spectrum chart shown in Figure 28 confirmed that the polymer had the repeating unit represented by formula (b9).

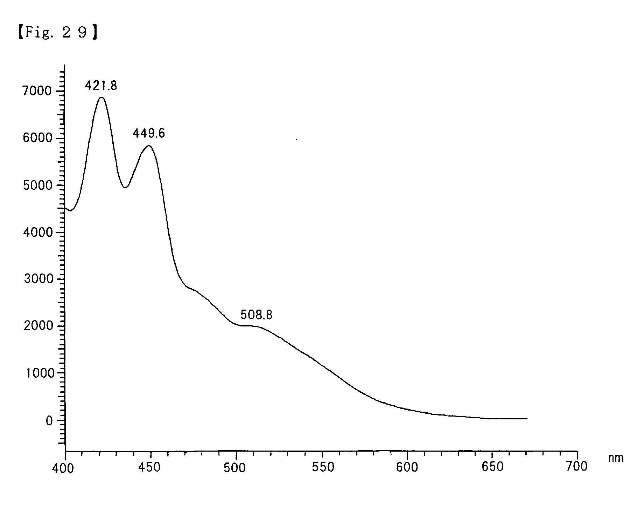

Also, the fluorescence spectrum chart in Figure 29 showed that the polymer having the repeating unit represented by formula (b9) was a luminescent polymer.

### (Working Example 9)

A polymer represented by formula (b10) was synthesized in the following steps by Reaction Process 11 below.

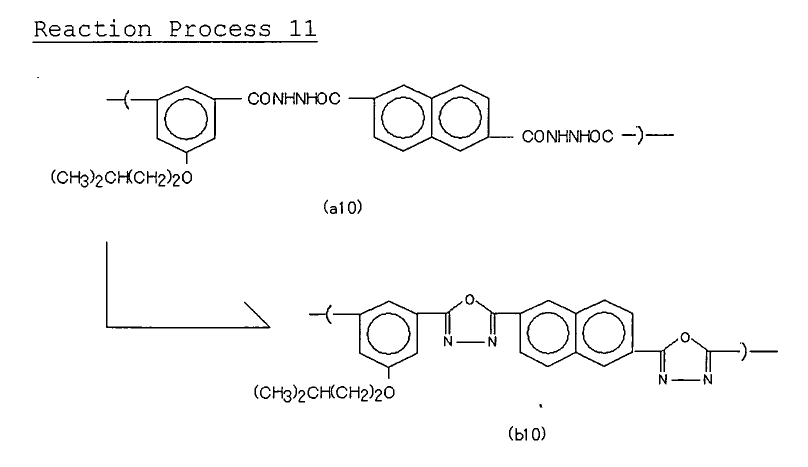

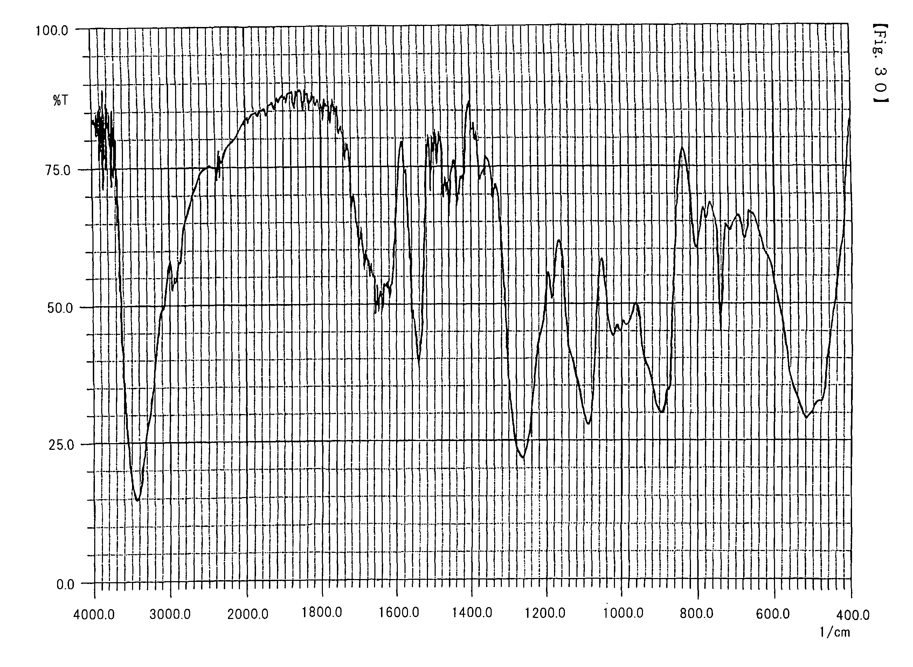

In a 200 ml three-necked flask were placed 0.36 g of a polymer having the repeating unit represented by formula (a10), and 75 g of polyphosphoric acid. The solution in the flask was reacted at 100°C to 110°C for 14 hours. After the completion of the reaction, the contents in the flask were cooled with ice. The cooled contents were neutralized by adding a 10% aqueous solution of sodium hydroxide. The neutralized contents were subjected to centrifugation. Sediment was obtained and taken out. The sediment was mixed with 450 ml of water. The mixture was again subjected to centrifugation. The sediment was taken out and dried. 0.1 g of a polymer was obtained. The IR spectrum chart shown in Figure 30 confirmed that the polymer had the repeating unit represented by formula (b10).

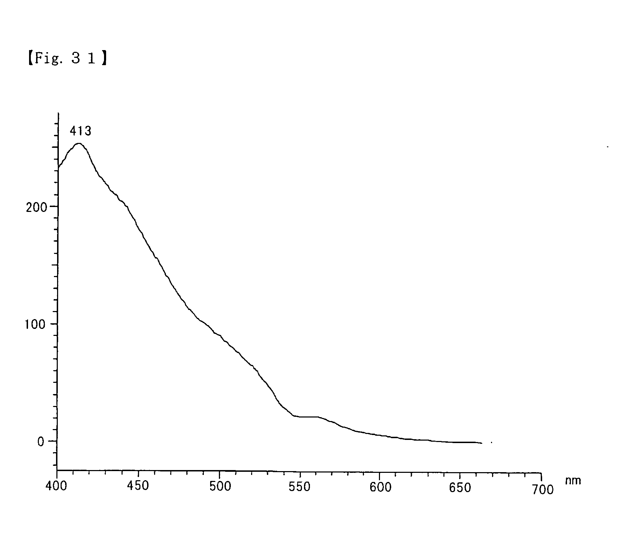

Also, the fluorescence spectrum chart in Figure 31 showed that the polymer having the repeating unit represented by formula (b10) was a luminescent polymer.

### (Working Example 10)

A polymer represented by formula (d11) was synthesized in the following steps by Reaction Process 12 below.

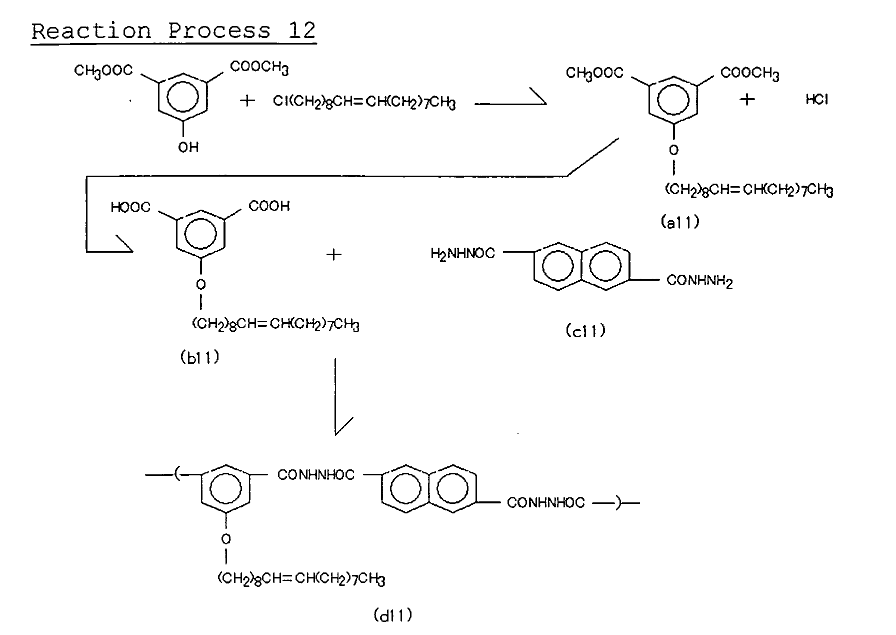

24.26 g of dimethyl 5-hydroxyisophthalate, 66.2 g of oleyl chloride, and 95.6 g of potassium carbonate were added to 600 ml of cyclohexanone. The obtained mixture was stirred under reflux at 177°C for 24 hours. Then, the product was cooled naturally. 700 ml of water and 700 ml of diethyl ether were added to the cooled product, which divided the obtained into an oil phase and a water phase. The oil phase was taken out.

In order to wash and neutralize the isolated oily liquid, 500 ml of a 15% aqueous solution of sodium hydroxide was added to the oily liquid. Then, the oil phase was again isolated by liquid-liquid separation. The isolated oily liquid was washed with water, and dried over anhydrous sodium sulfate. Then, the dried liquid was subjected to filtration. The filtrate was taken.

The filtrate was subjected to distillation at 85°C for 20 minutes. The remaining was naturally cooled, concentrated, and dried up. Compound (a11) was obtained.

40.6 g of compound (a11) and 70 ml of a 25 wt% aqueous solution of potassium hydroxide were added to 70 ml of 1,4-dioxane. The obtained mixture was stirred under reflux at 110°C for 21 hours.

The product liquid was cooled with ice, and the pH value thereof was adjusted to 2 with hydrochloric acid. The product liquid acidic with hydrochloric acid was filtered and solids were taken. The solids were washed with water and methanol in this order, and dried. A solid matter was obtained. The solid matter was dissolved in a mixture of 130 ml of acetone and 25 ml of methanol. The obtained solution was heated and then cooled, so that the solid matter was recrystallized. The recrystallized was dried, and 3.3 g of dicarboxylic acid (b11) was obtained.

In a 300 ml three-necked flask were placed 3.2 g of dicarboxylic acid (b11), 1.81 g of carbohydrazine (c11), 2.54 g of lithium chloride, 18.3 ml of pyridine, 5.2 g of diphenyl phosphite, and 27.9 ml of N-methyl-2-pyrrolidinone. The contents of the flask were stirred at 120°C for 65 hours. After the completion of the reaction, the flask was cooled with ice. Then the reaction product was poured into 800 ml of methanol, with the reaction product being stirred. The obtained mixture was filtered, and solids were obtained. The solids were washed with methanol and diethyl ether in this order, and dried. As a result, 3.9 g of a polymer having the repeating unit represented by formula (d11) was obtained.

A polymer having the repeating unit represented by formula (e11) was obtained by reacting the polymer having the repeating unit represented by formula (d11) in polyphosphoric acid at 110°C in the following steps by Reaction Process 13 below.

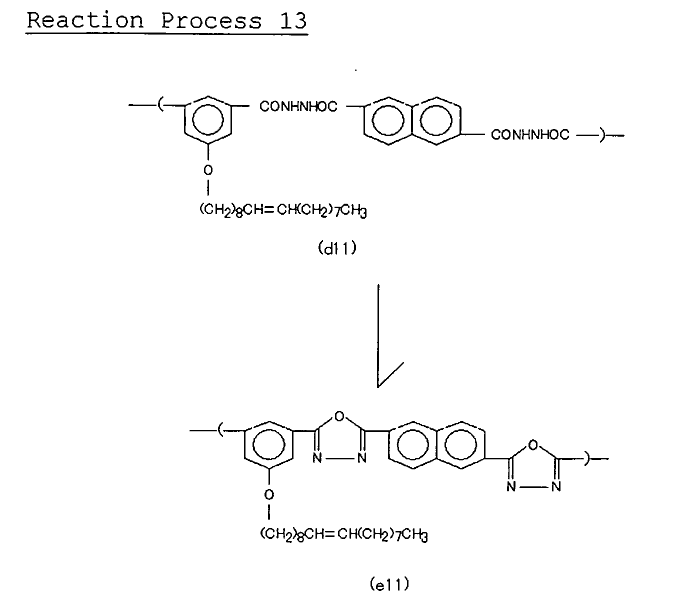

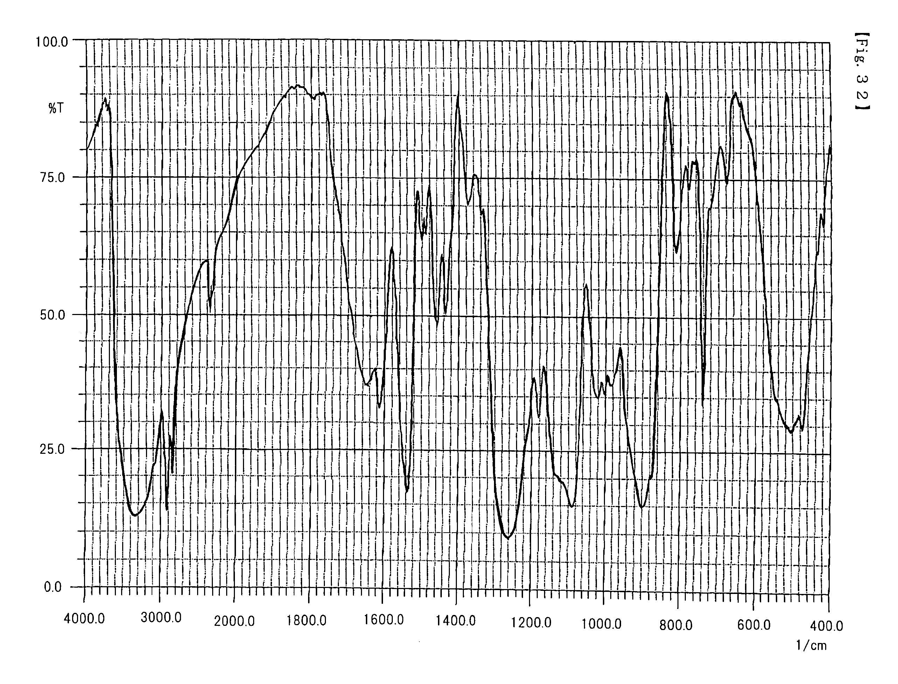

0.7 g of the polymer having the repeating unit represented by formula (d) was dehydrated by heating in 30 g of a polyphosphoric acid at 110°C for 18 hours. After the completion of the dehydration, the product liquid was introduced into ice water. The obtained was filtered with suction. Solids were taken. The solids were dried in vacuo, and 0.56 g of a polymer was obtained. The IR spectrum chart shown in Figure 32 confirmed that the polymer had the repeating unit represented by formula (e11).

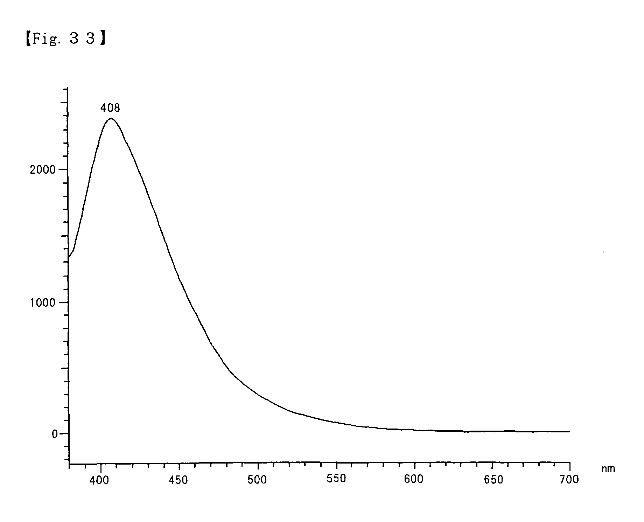

Also, the fluorescence spectrum chart in Figure 33 showed that the polymer having the repeating unit represented by formula (e11) was a luminescent polymer.

### Industrial Applicability

The present invention provides luminescent polymers which can easily be formed into a film or a sheet, and which can easily be incorporated into a luminescent element. The present invention also provides luminescent elements which can be produced easily by the employment of the luminescent polymers.

## Claims

1. A luminescent polymer having a repeating unit represented by formula (1) : 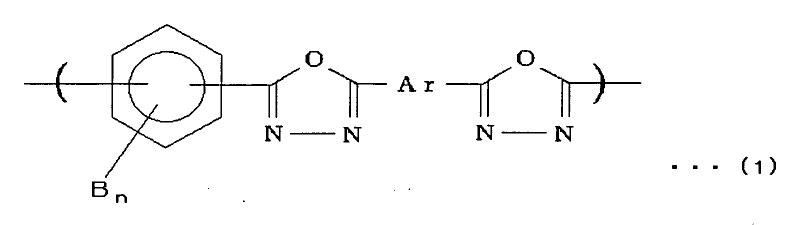 wherein Ar is a group represented by one of formulas (2)-(5); B is -Y-Ar¹, -Y-R, or a hydrogen atom, wherein Y is a single bond or -O-, Ar¹ is a group represented by formula (6), and R is an alkyl group or an alkenyl group; and n denotes an integer from 1 to 4, wherein Bs may be the same or different from each other when n is 2, 3, or 4; at least one of the Bs in formula (1) is -Y-Ar¹ or -Y-R when B or Bs in formula (2), (3), (4) or (5) are a hydrogen atom or hydrogen atoms; and at least one of the Bs in the group represented by any one of formulas (2) - (5) must be -Y-Ar¹ or -Y-R when B or Bs bonded to the benzene ring in formula (1) are a hydrogen atom or hydrogen atoms,
wherein the group represented by formula (2) is: 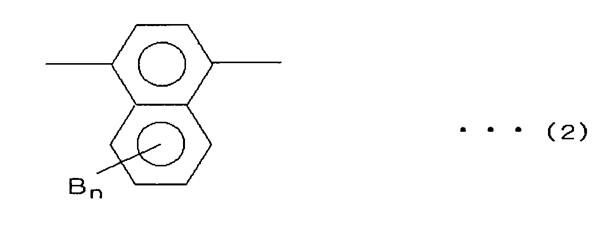 wherein B in formula (2) is the same as that defined above; n denotes an integer of 1 to 4, and when n is 2, 3, or 4, Bs may be the same or different from each other;
the group represented by the formula (3) is: 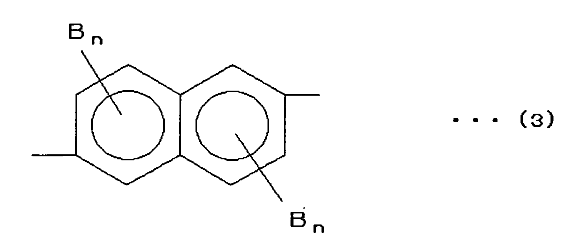 wherein each of the Bs in formula (3) is the same as that defined above, n denotes an integer of 1 to 3, and Bs may be the same or different from each other;
the group represented by the formula (4) is: 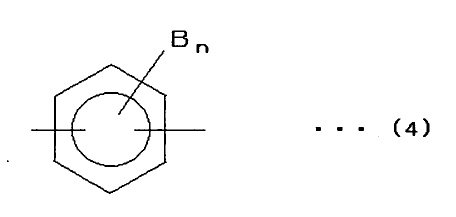 wherein B in formula (4) means the same as that defined above, n denotes an integer of 1 to 4, and when n is 2, 3, or 4, Bs may be the same or different from each other;
the group represented by the formula (5) is: 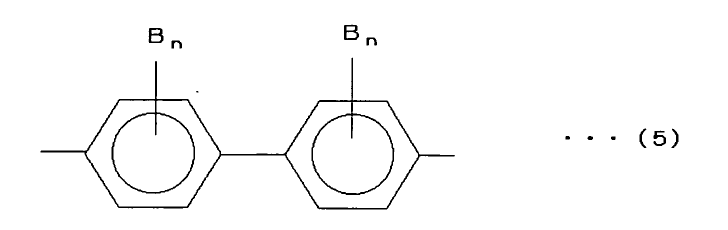 wherein each of the Bs is the same as that defined above, n denotes an integer of 1 to 4, and Bs may be the same or different from each other; and
the group represented by the formula (6) is: 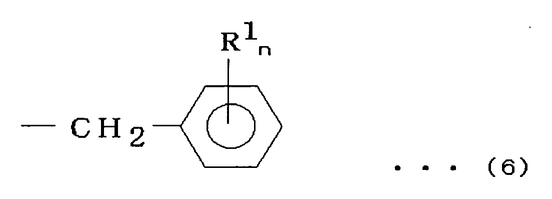 wherein R¹ is a hydrogen atom or an alkyl group, and n denotes an integer of 1 to 5.

2. A luminescent polymer having a repeating unit represented by formula (7): 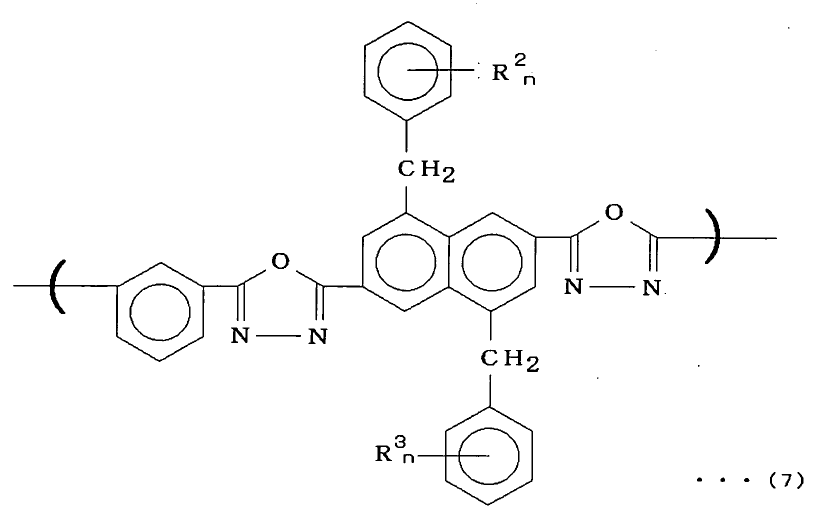 wherein each of R² and R³ is an alkyl group; n denotes an integer of 1-5; when n is 2, 3, 4 or 5, R²s may be the same or different from each other and R³s may be the same or different from each other; and R²(s) and R³(s) may be the same or different from each other.

3. A luminescent polymer having a repeating unit represented by formula (8) : 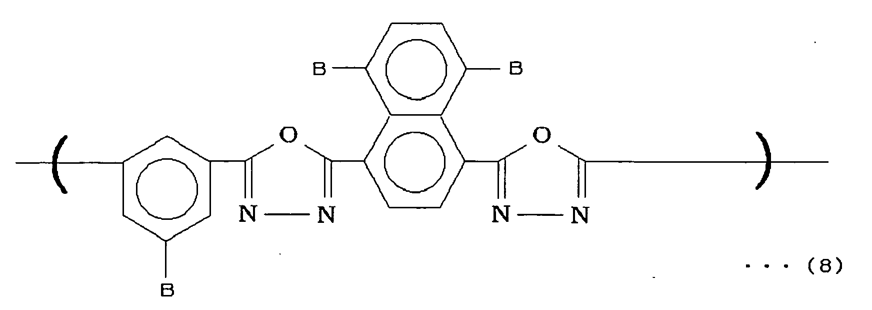 wherein each of the Bs in formula (8) means the same as that defined in claim 1; and at least one of the three Bs is -Y-Ar¹ or -Y-R, wherein Y, Ar¹ and R are the same as those defined in claim 1.

4. A luminescent polymer having a repeating unit represented by formula (9): 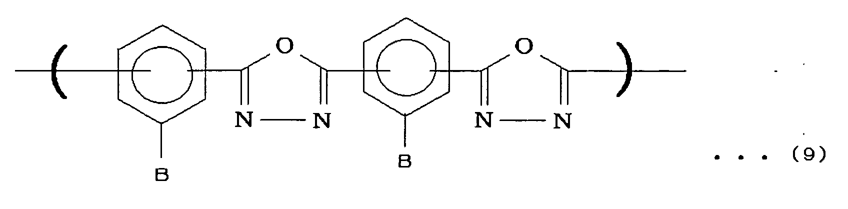 wherein each B in formula (9) is the same as that defined in claim 1, and at least one of the two Bs is -Y-Ar¹ or -Y-R.

5. A luminescent polymer having a repeating unit represented by formula (10): 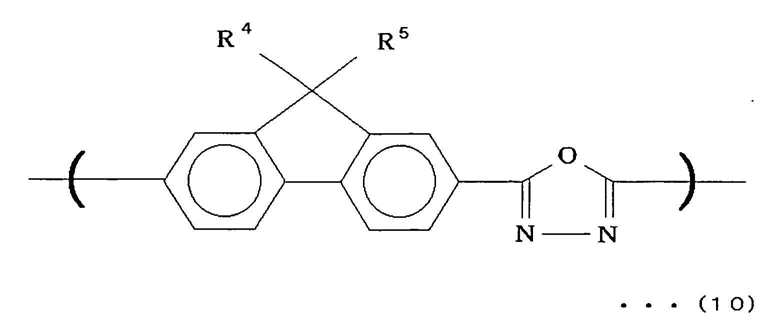 wherein each of R⁴ and R⁵ is an alkyl group, and R⁴ and R⁵ may be the same or different from each other.

6. A luminescent element comprising a pair of electrodes and a film of the luminescent polymer according to any one of claims 1-5 between the electrodes.

## Amended claims

### Amended claims under Art. 19.1 PCT

**1.** A luminescent polymer having a repeating unit represented by formula (1) : 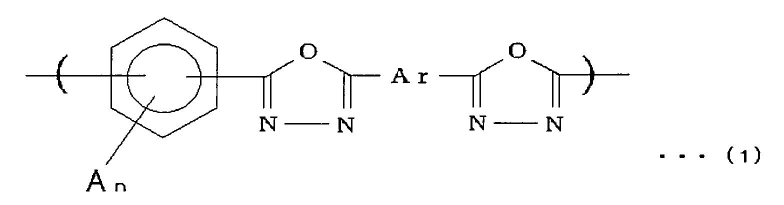 wherein Ar is a group represented by one of formulas (2)-(5); A is -O-Ar¹, or -O-R, wherein Ar¹ is a group represented by formula (6), and R is an alkyl group or an alkenyl group; and n denotes an integer from 1 to 4, wherein As may be the same or different from each other when n is 2, 3, or 4;
wherein the group represented by formula (2) is: 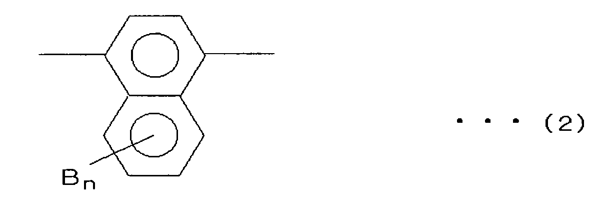 wherein B is -Y-Ar¹, -Y-R, or a hydrogen atom, wherein Y is a single bond or -O-, and Ar¹ and R are the same as those defined above; n denotes an integer of 1 to 4, and when n is 2, 3, or 4, Bs may be the same or different from each other;
the group represented by the formula (3) is: 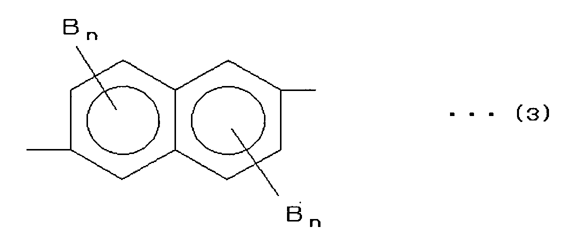 wherein each of the Bs in formula (3) is the same as that defined above, n denotes an integer of 1 to 3, and Bs may be the same or different from each other;
the group represented by the formula (4) is: 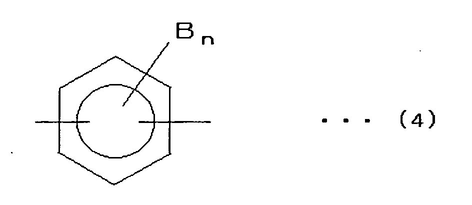 wherein B in formula (4) means the same as that defined above, n denotes an integer of 1 to 4, and when n is 2, 3, or 4, Bs may be the same or different from each other;
the group represented by the formula (5) is: 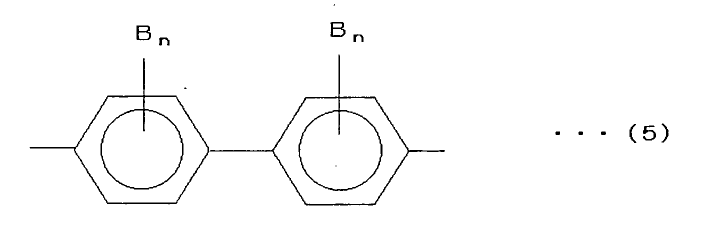 wherein each of the Bs is the same as that defined above, n denotes an integer of 1 to 4, and Bs may be the same or different from each other; and
the group represented by the formula (6) is: 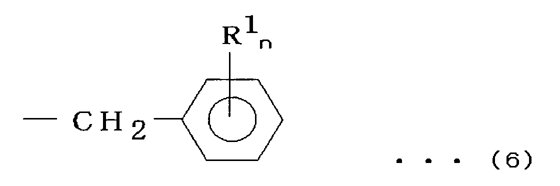 wherein R¹ is a hydrogen atom or an alkyl group, and n denotes an integer of 1 to 5.

**2.** A luminescent polymer having a repeating unit represented by formula (7): 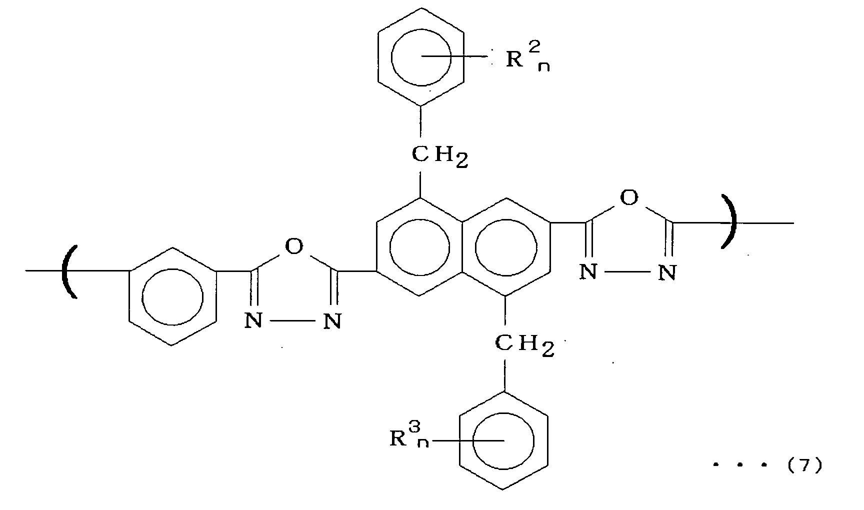 wherein each of R² and R³ is an alkyl group; n denotes an integer of 1-5; when n is 2, 3, 4 or 5, R²s may be the same or different from each other and R³s may be the same or different from each other; and R²(s) and R³(s) may be the same or different from each other.

**3.** A luminescent polymer having a repeating unit represented by formula (8) : 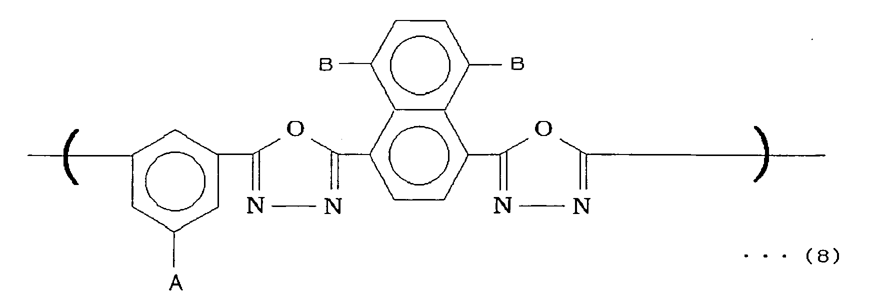 wherein A and Bs in formula (8) respectively mean the same as those defined in claim 1.

**4.** A luminescent polymer having a repeating unit represented by formula (9): 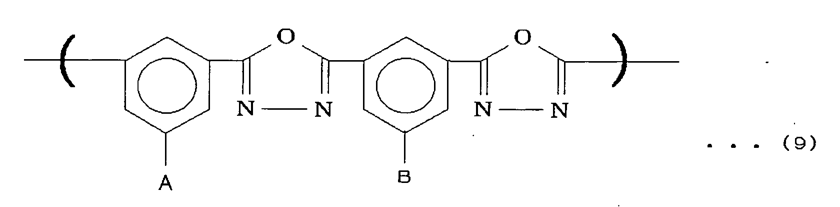 wherein A and Bs in formula (9) respectively mean the same as those defined in claim 1.

**5.** deleted.

**6.** A luminescent element comprising a pair of electrodes and a film of the luminescent polymer according to any one of claims 1-4 between the electrodes.

Statement under Art. 19.1 PCT
**1.** Claim 1 is amended so as to recite that substituent A makes an ether linkage with the benzene ring included in formula (1).
 Also, amended claim 1 differentiates Ar¹ included in A bonded to the benzene ring of formula (1) from Ar¹ in formula (1).

**2.** Claim 3 is amended so as to recite that substituent A makes an ether linkage with the benzene ring included in formula (8).

**3.** Claim 4 is amended so as to recite that substituent A makes an ether linkage with the benzene ring included in formula (9).

**4.** Claim 5 is deleted from the application.

**5.** Claim 6 is amended so that it is dependent from any one of claims 1-4, as a result of the deletion of claim 5.
